(19) Europäisches Patentamt
European Patent Office
Office européen des brevets

(11) EP 2 478 680 B1

(12) FASCICULE DE BREVET EUROPEEN

(45) Date de publication et mention
de la délivrance du brevet:
13.07.2016 Bulletin 2016/28

(51) Int Cl.:
H03M 13/11 (2006.01)          H03M 13/37 (2006.01)
H03M 13/15 (2006.01)          H03M 13/23 (2006.01)
H03M 13/29 (2006.01)          H04B 7/155 (2006.01)
H04L 1/00 (2006.01)           H04L 1/06 (2006.01)
H04L 25/03 (2006.01)

(21) Numéro de dépôt: 10770584.0

(22) Date de dépôt: 17.09.2010

(86) Numéro de dépôt international:
PCT/FR2010/051942

(87) Numéro de publication internationale:
WO 2011/033237 (24.03.2011 Gazette 2011/12)

(54) **PROCEDE DE TRANSMISSION D'UN SIGNAL NUMERIQUE POUR UN SYSTEME MARC AVEC RELAIS FULL-DUPLEX, PRODUIT PROGRAMME ET DISPOSITIF RELAIS CORRESPONDANTS**

VERFAHREN ZUR ÜBERTRAGUNG EINES DIGITALEN SIGNALS FÜR EIN MARC-SYSTEM MIT EINEM VOLLDUPLEX-RELAIS SOWIE ZUGEHÖRIGES PROGRAMMPRODUKT UND RELAISVORRICHTUNG

METHOD FOR TRANSMITTING A DIGITAL SIGNAL FOR A MARC SYSTEM WITH A FULL-DUPLEX RELAY, AND CORRESPONDING PROGRAM PRODUCT AND RELAY DEVICE

(84) Etats contractants désignés:
AL AT BE BG CH CY CZ DE DK EE ES FI FR GB
GR HR HU IE IS IT LI LT LU LV MC MK MT NL NO
PL PT RO SE SI SK SM TR

(30) Priorité: 17.09.2009 FR 0956373

(43) Date de publication de la demande:
25.07.2012 Bulletin 2012/30

(73) Titulaire: Orange
75015 Paris (FR)

(72) Inventeurs:
• HATEFI, Atoosa
F-75015 Paris (FR)
• VISOZ, Raphaël
F-92130 IssyLes Moulineaux (FR)
• BERTHET, Antoine
F-92290 Chatenay Malabry (FR)

(74) Mandataire: Jeune, Pascale
Orange
IMTW/OLPS/IPL/PAT
Orange Gardens
44 Avenue de la République
CS 50010
92326 Châtillon Cedex (FR)

(56) Documents cités:
EP-A1- 1 729 435     WO-A2-2006/071187

• CHRISTOPH HAUSI ET AL: "Joint Network-Channel Coding for the Multiple-Access Relay Channel", SENSOR AND AD HOC COMMUNICATIONS AND NETWORKS, 2006. SECON '06. 2 006 3RD ANNUAL IEEE COMMUNICATIONS SOCIETY ON, IEEE, PI, 1 janvier 2006 (2006-01-01), pages 817-822, XP031012271, ISBN: 978-1-4244-0626-5 cité dans la demande
• XIAODONG WANG ET AL: "Iterative (Turbo) Soft Interference Cancellation and Decoding for Coded CDMA", IEEE TRANSACTIONS ON COMMUNICATIONS, IEEE SERVICE CENTER, PISCATAWAY, NJ, US, vol. 47, no. 7, 1 juillet 1999 (1999-07-01), XP011009462, ISSN: 0090-6778
• JOSEPH THOMAS ET AL: "Space-Time Iterative Receivers for Narrowband Multichannel Networks", IEEE TRANSACTIONS ON COMMUNICATIONS, IEEE SERVICE CENTER, PISCATAWAY, NJ, US, vol. 50, no. 7, 1 juillet 2002 (2002-07-01), XP011070965, ISSN: 0090-6778

EP 2 478 680 B1

- TUYEN BUI ET AL: "Iterative approaches of cooperative transmission based on superposition modulation", COMMUNICATIONS AND INFORMATION TECHNOLOGIES, 2007. ISCIT '07. INT ERNATIONAL SYMPOSIUM ON, IEEE, PI, 1 octobre 2007 (2007-10-01), pages 1423-1428, XP031166684, ISBN: 978-1-4244-0976-1
- JUN HU ET AL: "Low Density Parity Check Codes over Wireless Relay Channels", IEEE TRANSACTIONS ON WIRELESS COMMUNICATIONS, IEEE SERVICE CENTER, PISCATAWAY, NJ, US, vol. 6, no. 9, 1 septembre 2007 (2007-09-01), pages 3384-3394, XP011195936, ISSN: 1536-1276
- TAE-WON YUNE ET AL: "Iterative multiuser detection with spectral efficient relaying protocols for single-carrier transmission", IEEE TRANSACTIONS ON WIRELESS COMMUNICATIONS, IEEE SERVICE CENTER, PISCATAWAY, NJ, US, vol. 7, no. 7, 1 juillet 2009 (2009-07-01) , pages 3789-3797, XP011264152, ISSN: 1536-1276

**Description**

**Domaine de l'invention**

Le domaine de l'invention est celui de la transmission de données codées dans un réseau MARC. Un réseau MARC est un système de télécommunication à au moins quatre noeuds comprenant au moins deux émetteurs, un relais et un récepteur. Plus précisément, l'invention se rapporte au codage de réseau et elle concerne l'amélioration de la qualité de la transmission des données, et en particulier l'amélioration des performances du décodage correcteur d'erreurs dans un récepteur.

L'invention s'applique notamment, mais non exclusivement, à la transmission de données via des réseaux mobiles, par exemple pour des applications temps réel.

**Art antérieur**

Les réseaux, en particulier mobiles, sont à la recherche de gains significatifs en termes de capacité, de fiabilité, de consommation et autres. Le canal de transmission d'un réseau mobile est réputé difficile et conduit à une fiabilité de transmission relativement médiocre. Des progrès importants ont été réalisés ces dernières années, en matière de codage et de modulation, notamment pour des considérations de consommation et de capacité. En effet, dans un réseau mobile où plusieurs émetteurs/récepteurs partagent les mêmes ressources (temps, fréquence et espace) il faut réduire au maximum la puissance d'émission.

Cette réduction va à l'encontre de la couverture et donc de la capacité du système et plus généralement de ses performances.

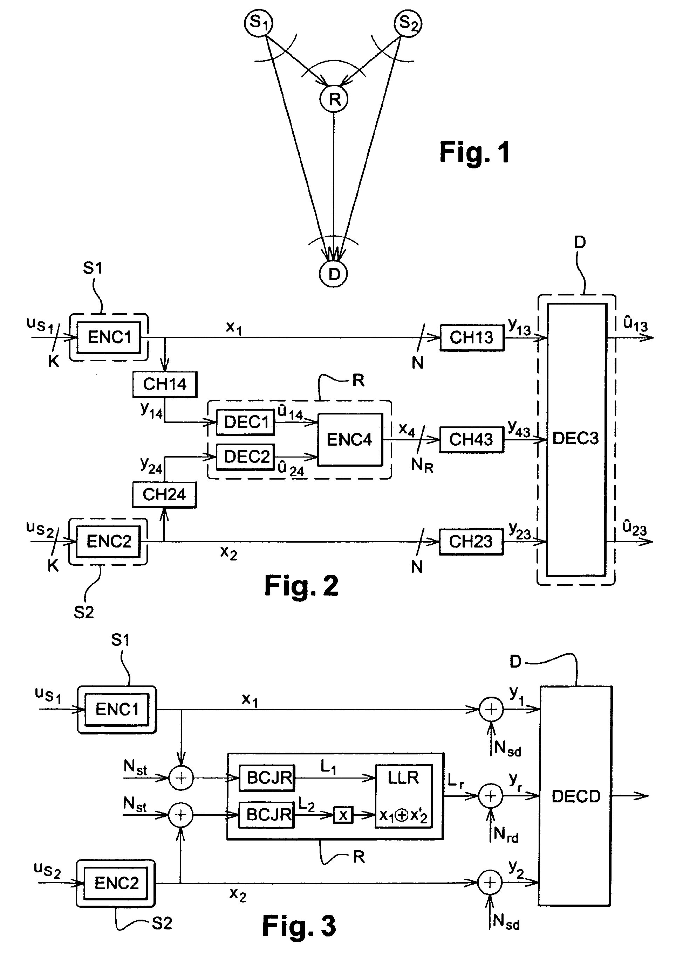

Pour augmenter la couverture, fiabiliser les communications et plus généralement améliorer les performances, une approche consiste à s'appuyer sur des relais pour augmenter l'efficacité spectrale et donc améliorer l'efficacité de transmission et la fiabilité des systèmes. La topologie des systèmes MARC illustrée par la figure 1 est telle que les sources, noeuds $S_1$ et $S_2$, diffusent leurs séquences d'informations codées à l'attention du relais R et du destinataire D. Le relais décode les signaux reçus issus des sources $S_1$ et $S_2$ et ré-encode conjointement ceux-ci en ajoutant une redondance propre créant un code de réseau spatialement distribué. A la destination D, le décodage des trois séquences codées spatialement distribuées, comprenant les deux séquences codées reçues issues directement des sources S1 et S2 et la séquence codée issue du relais, repose sur des algorithmes de décodage conjoint canal/ réseau.

Le codage de réseau est une forme de coopération selon laquelle les noeuds du réseau partagent non seulement leurs ressources propres (puissance, bande, etc.) mais également leur capacité de calcul, pour créer un codage distribué de plus en plus puissant au fur et à mesure que l'information se propage à travers les noeuds. Il amène des gains substantiels en termes de diversité et de codage et donc de fiabilité de transmission.

On distingue deux types de fonctionnement pour le relais : le mode half-duplex et le mode full-duplex.

Selon le mode half-duplex, on distingue deux phases de transmission qui correspondent à des intervalles de transmission différents car le relais est incapable de recevoir et d'émettre simultanément. Pendant la première phase qui comprend les 1$^{er}$ intervalles de transmission (time slots), les deux sources émettent mais pas le relais. Le relais décode/ré-encode conjointement pour déduire le signal à émettre lors des prochains intervalles de transmission. Pendant la deuxième phase qui comprend les 2$^e$ intervalles de transmission, le relais émet le signal déterminé pendant les 1$^{er}$ intervalles de transmission et les sources émettent les deuxièmes séquences de parité relatives aux mêmes informations que celles émises pendant les 1$^{er}$ intervalles de transmission. Les relais de type half-duplex sont attractifs du fait d'un schéma de communication simple et du fait de la facilité de les mettre en oeuvre et de leur coût réduit qui en découlent.

Selon le mode full-duplex, le relais reçoit les nouveaux blocs d'information de la part des deux sources et transmet simultanément au destinataire son mot de code basé sur les blocs reçus précédemment. Comparativement au relais half-duplex, le relais full-duplex permet d'atteindre une capacité plus grande.

Les articles [1] et [2] ainsi que la demande de brevet EP 1 729 435 décrivent un codage conjoint canal/réseau pour un système MARC, illustré par la figure 2. Le système MARC considéré est tel que tous les liens CH14, CH24, CH13, CH43 et CH23 sont orthogonaux, en outre les liens entre les deux sources et le relais sont supposés parfaitement fiables. Dans la demande le lien est le canal de communication entre deux ou plusieurs noeuds, il peut être physique ou logique. Lorsque le lien est physique alors il est généralement appelé canal. Les deux sources S1, S2 diffusent l'information codée au relais R et au destinataire D pendant la première phase de transmission. Le relais R combine linéairement les flux supposés parfaitement décodés des deux utilisateurs selon un schéma de codage de réseau linéaire. Pendant la seconde phase, le relais émet une séquence de parité supplémentaire au destinataire D. Ce code conjoint canal/réseau peut être considéré, une fois tous les flux reçus, stockés et réorganisés au niveau du destinataire, comme un code conjoint canal/réseau spatialement distribué qui peut être itérativement décodé. Ce code conjoint amène des gains substantiels en termes de diversité et de codage.

S. Yang et R. Koetter [3] ont évalué les performances du codage de réseau pour un système MARC, illustré par la figure 3, avec liens orthogonaux mais en présence de liens sources-relais bruités. Les auteurs proposent la technique "soft decode and forward" qui repose sur la génération d'une distribution de probabilités discrète sur les bits à transmettre obtenue par un algorithme calculant les probabilités à posteriori (APP) sur les bits/symboles codés. Chaque source S1, S2 génère un mot de code transmis au relais R. Le relais R les décode sous la forme d'un rapport logarithmique de probabilités (LLR) en utilisant un algorithme de décodage BCJR, du nom de ses auteurs L.Bahl, J.Cocke, F.Jelinek, and J.Raviv [4], puis effectue un codage de réseau pondéré sans mémoire correspondant à la somme modulo deux bit à bit (opération XOR) des deux mots de code reçus, le codage pondéré consistant à générer à partir des LLR $L_1$, $L_2$ des deux sources un troisième LLR $L_R$ correspondant à l'opération XOR. Ce troisième LLR est finalement transmis de façon analogique vers la destination D. Ainsi, le destinataire dispose de trois observations : celles émanant des deux sources et le LLR. Le destinataire effectue conjointement et d'une manière itérative un décodage des flux de la source $S_1$ et de la source $S_2$ en exploitant l'information supplémentaire fournie par le relais. L'article décrit que, même pour des liens $S_1 \rightarrow R$ et $S_2 \rightarrow R$ sévèrement bruités, le codage de réseau apporte un gain de codage par rapport à un schéma sans coopération, donc sans relais. Le procédé est décrit dans le cas d'une modulation BPSK et ne peut pas être transposé à une modulation avec un ordre supérieure à deux car l'expression calculée lors de la 3$^e$ étape ne peut s'appliquer que pour une modulation d'ordre deux ou quatre (ex.QPSK).

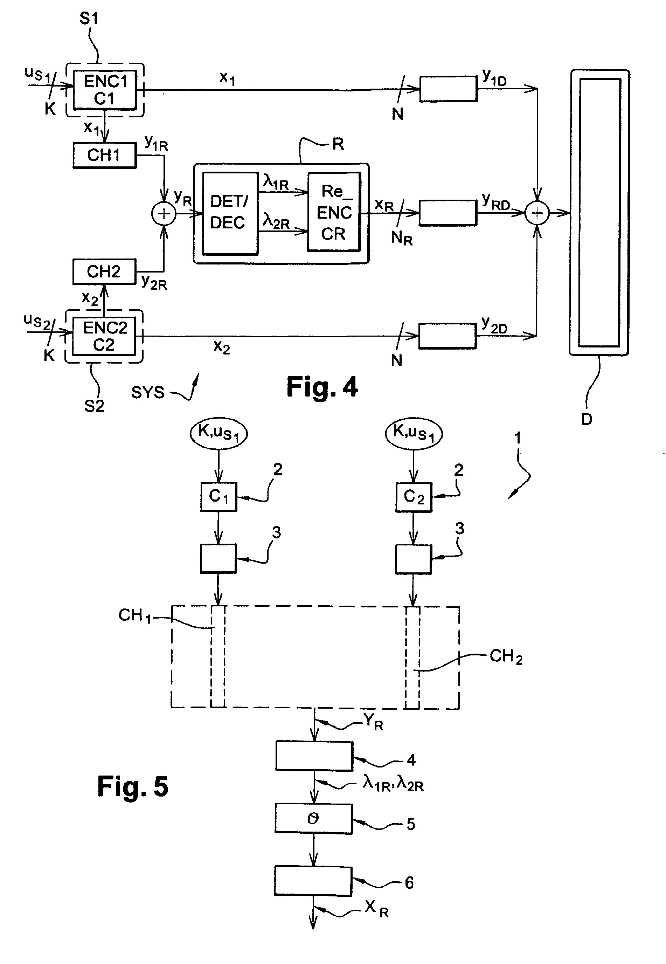

Finalement, le document [5] divulgue en Figure 5 une architecture de récepteur, dans un système à 3 noeuds dont 2 noeuds source et un noeud destination, chaque noeud source relayant alternativement les données de l'autre noeud source.

Dans ces différents systèmes connus, les erreurs de décodage sont réduites uniquement en l'absence d'interférence puisque le système MARC considéré est supposé sans interférence du fait des liens orthogonaux. En outre, la contrainte qui consiste à imposer des liens orthogonaux conduit à une utilisation non optimale de la ressource spectrale donc à une limitation de la capacité du réseau.

**Caractéristiques principales de l'invention**

L'invention a pour objet le procédé de transmission de la revendication indépendante 1.

L'invention a en outre pour objet un relais full-duplex destiné à un système MARC, comme revendiqué dans La revenducation indépendante 5

Une étape d'émission par les émetteurs intervient de manière simultanée ce qui permet d'utiliser au maximum la ressource spectrale commune. Il y a donc interférence entre les signaux reçus par le relais et la destination du fait de la superposition des signaux sources lors de la transmission d'une part entre les émetteurs et le relais et d'autre part entre les émetteurs et la destination (le récepteur).

Ainsi, l'invention repose en particulier sur l'introduction d'une étape de détection/décodage conjoint et d'un codage conjoint dans le relais, ce qui permet de séparer les flux émis simultanément par les deux sources et de faire bénéficier à l'ensemble des émetteurs dispersés du gain de codage d'un code réseau spatialement distribué sans diminuer l'efficacité spectrale. En effet, l'approche de l'invention permet de mettre en oeuvre, dans les récepteurs, un décodage itératif, s'appuyant sur une redondance générée dans les relais, sans nécessiter d'augmenter la puissance dans les émetteurs pour atteindre une augmentation de la couverture du système et de l'efficacité spectrale.

Selon un mode de réalisation particulier, un procédé de transmission est tel que l'étape de détection/décodage conjoint itératif met en oeuvre un décodage dur.

Ce mode de décodage avec une décision dure sur la valeur de chacun des bits reçus dans le relais est plus particulièrement adapté à un système MARC dans lequel les liens sont parfaitement fiables. Dans ce contexte, le relais peut décoder sans erreur l'information émanant des sources. Un décodage dur est donc particulièrement adapté à un tel système MARC car il est de complexité réduite par rapport à un décodage souple et rapide à mettre en oeuvre.

Selon un mode de réalisation particulier, un procédé de transmission est tel que l'étape de détection/décodage conjoint itératif met en oeuvre un décodage souple et l'étape de codage conjoint met en oeuvre un codage souple et une marginalisation effectuée au niveau bit.

Ce mode de décodage est plus particulièrement adapté à un système MARC avec des canaux à évanouissements de Rayleigh et avec une méconnaissance aux niveaux des sources des canaux sources/relais. Dans ce contexte, il existe une probabilité non nulle que le relais décode imparfaitement l'information émanant des sources. Le choix d'un décodage souple, permet de limiter la propagation d'erreurs par le relais.

Selon un mode de réalisation particulier, un procédé de transmission est tel que l'étape de détection/décodage conjoint itératif met en oeuvre un décodage souple et l'étape de codage conjoint met en oeuvre un codage souple et une compression.

Ce mode de décodage est plus particulièrement adapté à un système MARC avec des canaux à évanouissements de Rayleigh et avec une méconnaissance aux niveaux des sources des canaux sources/relais. Dans ce contexte, il existe une probabilité non nulle que le relais décode imparfaitement l'information émanant des sources. Le choix d'un décodage souple permet de limiter la propagation d'erreurs par le relais. En outre, le codage souple suivi d'une compression permet d'utiliser n'importe quelle modulation au relais contrairement au mode avec codage dur et marginalisation qui impose l'utilisation d'une modulation BPSK au relais.

Selon un mode de réalisation particulier, un procédé de transmission est tel que la compression est effectuée en utilisant un critère d'erreur quadratique moyenne non corrélée (MMSUE).

L'utilisation du critère MMSUE permet d'effectuer une estimation optimale au relais à partir des probabilités à posteriori et permet donc de maximiser le SNR à la destination en réduisant le nombre d'erreurs dans le relais.

L'invention est caractérisée par une compression basée sur la détermination d'une matrice des espérances de symboles.

Selon un mode de réalisation particulier, un procédé de transmission comprend en outre un ordonnancement dans chaque émetteur tel que l'émetteur n'émet pas de mot de code pendant N intervalles de transmission après avoir émis B mots de code, B étant un paramètre.

Typiquement, une trame contient B mots de code (soit B blocs chacun correspondant à K bits d'information). Selon ce mode, on impose une période de silence aux deux émetteurs après l'émission de B mots de code qui correspondent à B blocs de K bits, c'est-à-dire après l'émission d'une trame par chacun des deux émetteurs. Par contre, pendant cette période de silence le relais du système MARC émet l'information de redondance déterminée sur la base du dernier bloc reçu de chaque émetteur. Ce mode a par conséquent pour avantage de permettre au récepteur de décoder ces deux derniers blocs comme les blocs précédents, c'est-à-dire en bénéficiant d'une information de redondance déterminée et émise par le relais. Cet avantage est toutefois atténué par l'impact sur l'efficacité spectrale du fait de la période de silence et par l'introduction d'un temps de latence pour débuter une nouvelle trame de B blocs.

L'invention a en outre pour objet le procédé de réception de la revendication indépendante 7 ou de la revendication indépendante 8.

L'invention a en outre pour objet le récepteur de la revendication indépendante 9 ou de la revendication indépendante 10.

Ce procédé de réception et ce récepteur ont pour avantage d'être adaptés à un système MARC mettant en oeuvre un procédé de transmission selon l'invention.

Les différents modes de réalisation précédents peuvent être combinés ou pas avec un ou plusieurs de ces modes pour définir un autre mode de réalisation.

L'invention a en outre pour objet un système MARC, éventuellement MIMO, adapté pour la mise en oeuvre d'un procédé selon l'invention.

Ainsi, un système MARC selon l'invention, comprend un relais selon l'invention.

Selon une implémentation préférée, les étapes du procédé de transmission, respectivement de réception, sont déterminées par les instructions d'un programme de transmission, respectivement de réception, incorporé dans un ou plusieurs circuits électronique telle des puces elle-même pouvant être disposées dans des dispositifs électroniques du système MARC. Le procédé de transmission, respectivement de réception, selon l'invention peut tout aussi bien être mis en oeuvre lorsque ce programme est chargé dans un organe de calcul tel un processeur ou équivalent dont le fonctionnement est alors commandé par l'exécution du programme.

En conséquence, l'invention s'applique également à un programme d'ordinateur, notamment un programme d'ordinateur sur ou dans un support d'information, adapté à mettre en oeuvre l'invention. Ce programme peut utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter un procédé selon l'invention.

Le support d'information peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

Alternativement, le support d'information peut être un circuit intégré dans lequel le programme est incorporé, le circuit étant adapté pour exécuter ou pour être utilisé dans l'exécution du procédé en question.

D'autre part, le programme peut être traduit en une forme transmissible telle qu'un signal électrique ou optique, qui peut être acheminé via un câble électrique ou optique, par radio ou par d'autres moyens. Le programme selon l'invention peut être en particulier téléchargé sur un réseau de type Internet.

**Liste des figures**

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 est un schéma illustrant la topologie de base des systèmes MARC,

- la figure 2 est un premier exemple d'un système MARC de l'art antérieur avec des liens orthogonaux entre les différents noeuds,
- la figure 3 est un second exemple d'un système MARC de l'art antérieur avec des liens orthogonaux entre les différents noeuds,
- la figure 4 est un exemple d'un système MARC selon l'invention avec liens non orthogonaux entre les noeuds du système,
- la figure 5 est un organigramme simplifié du procédé de transmission selon l'invention mis en oeuvre par un système MARC illustré par la figure 4,
- la figure 6 est un schéma d'un premier mode de réalisation d'un relais selon l'invention,
- la figure 7 est un schéma d'un deuxième mode de réalisation d'un relais selon l'invention,
- la figure 8 est un schéma d'un troisième mode de réalisation d'un relais selon l'invention,
- la figure 9 est un schéma d'un exemple de compression mise en oeuvre au relais,
- la figure 10 est un schéma détaillé d'un détecteur/décodeur conjoint DET/DEC d'un relais illustrés par les figures 6, 7 ou 8,
- la figure 11 est un schéma détaillé d'un MUD d'un détecteur/décodeur conjoint DET/DEC illustré par la figure 10,
- la figure 12 est un schéma détaillé d'un décodeur DECi d'un détecteur/décodeur conjoint DET/DEC illustré par la figure 10,
- la figure 13 est un schéma d'un algorithme itératif de décodage conjoint mis en oeuvre dans un récepteur d'un système MARC avec relais full-duplex, selon l'invention,
- la figure 14 est un schéma de séquençage des opérations au relais selon l'invention,
- la figure 15 est un schéma d'un décodeur mis en oeuvre dans un récepteur d'un système MARC avec relais full-duplex, selon l'invention.

## Description de modes de réalisation particuliers

L'invention propose une nouvelle approche de l'utilisation d'un relais d'un système MARC illustré par la figure 4, pour améliorer l'efficacité spectrale de la transmission selon un procédé 1 selon l'invention illustré par la figure 5, tout en permettant un décodage simple et efficace dans le récepteur.

Il n'y a aucune contrainte sur le canal de transmission ; il peut être à évanouissement rapide (fast fading) ou lent (slow fading), il peut être sélectif en fréquence, et il peut être MIMO. Dans la suite de la description, les deux sources, le relais, et la destination sont supposées parfaitement synchronisés et les deux sources sont indépendantes (il n'y a pas de corrélation entre elles).

Les notations suivantes sont utilisées dans la demande.

Tous les vecteurs utilisent des caractères gras.

Un vecteur $\mathbf{v}$ a son $\mathbf{k}^{\text{ième}}$ élément noté $[\mathbf{v}]_k$ ou $\mathbf{v}_k$.

Une fonction multidimensionnelle F porte en entrée sur une matrice $\mathbf{A}$ de dimension $m \times q$ où chaque élément $a_{ij}$ (pour tout i=1, ..,m et j=1,..,q) appartient à l'ensemble E et détermine une matrice $\mathbf{B}$ de dimension $n \times p$ dont chaque élément $b_{ij}$ (pour tout i=1, ..., n et j=1, ...,p) appartient à l'ensemble G, telle que F($\mathbf{A}$) = $\mathbf{B}$ dénotée :

$$F : E^{m \times q} \to G^{n \times p}$$

La densité de probabilité d'une variable aléatoire complexe $x$ suivant une distribution gaussienne à symétrie circulaire de moyenne $\mu_x$ et de covariance $\sigma_x^2$ est notée : $CN(\mu_x, \sigma_x^2)$.

$F_2$ est le corps de Galois à 2 éléments, R le corps des réels et C le corps des complexes. Soit $\mathbf{X}$ une matrice de dimension $N \times M$ appartenant au corps E, c'est-à-dire $\mathbf{X} \in E^{N,M}$, $\mathbf{x}_k$ dénote sa $k^{\text{ième}}$ colonne (k=1,...,M).

Les fonctions utilisent des caractères majuscules non-italiques.

Soit $\mathbf{x}$ une variable aléatoire discrète avec la loi de probabilité $p(x)$, E($\mathbf{x}$) désigne l'espérance mathématique de x:

$$E(x) = \sum_i x_i p(x_i)$$

Les deux sources S1, S2 (les deux émetteurs) statistiquement indépendantes et équipées respectivement de $T_{S_1}$ et $T_{S_2}$ antennes, effectuent un codage 2 des données d'information $\mathbf{u}_{S_1}$, $\mathbf{u}_{S_2}$ segmentées par bloc de K bits en appliquant des schémas de modulation et de codage canal espace temps $C_1$ et $C_2$ mis en oeuvre par des codeurs ENCI, et ENC2. Le schéma de modulation et de codage $C_1$, respectivement $C_2$, d'une source permet donc d'associer 2 à tout vecteur d'information $\mathbf{u}_{S_1} \in F_2^K$, respectivement $\mathbf{u}_{S_2} \in F_2^K$, des symboles codés et modulés $\mathbf{X}_{S_1} \in \chi_1^{T_{S_1} \times N}$, respectivement $\mathbf{X}_{S_2} \in \chi_2^{T_{S_2} \times N}$ appartenant aux constellations complexes $\chi_1$ et $\chi_2$ de cardinalités $|\chi_1| = 2^p$ et $|\chi_2| = 2^q$ ($p, q \in \mathbf{N}$) :

$$C_1 : F_2^K \rightarrow \chi_1^{T_{S_1} \times N}$$

$$C_2 : F_2^K \rightarrow \chi_2^{T_{S_2} \times N}$$

$\mathbf{X}_{S_1}$ et $\mathbf{X}_{S_2}$ sont dénommés par la suite mots de code finaux émis respectivement par les sources $S_1$ et $S_2$.

Les sources émettent 3 ensuite les mots de codes finaux $\mathbf{X}_{S_1} \in \chi_1^{T_{S_1} \times N}$ et $\mathbf{X}_{S_2} \in \chi_2^{T_{S_2} \times N}$ pendant N utilisations de canal (N intervalles de transmission) à destination du relais et du récepteur.

Le relais R équipé de $R_X$ antennes de réception et $T_R$ antennes d'émission reçoit les données $\mathbf{Y}_R \in C^{R_X \times N}$ qui sont une superposition des mots de code $\mathbf{Y}_{1R} \in C^{R_X \times N}$, $\mathbf{Y}_{2R} \in C^{R_X \times N}$ (ou au moins certains d'entre eux) transmis par le canal CH1, CH2. Dans la suite du document, les termes génériques "mots de code" sont utilisés en relation avec $\mathbf{X}_{S_1}$ et $\mathbf{X}_{S_2}$ et plus généralement pour tous vecteurs/matrices obtenus à l'issu d'un codage avec un schéma de modulation et de codage Ci.

Les mots de code $\mathbf{Y}_{1R}$, $\mathbf{Y}_{2R}$ sont donc une version perturbée des mots de code émis $\mathbf{X}_{S_1}$, $\mathbf{X}_{S_2}$ et leur superposition peut s'exprimer sous la forme :

$$\mathbf{y}_{R.k} = \mathbf{y}_{1R.k} + \mathbf{y}_{2R.k}$$
$$= \sum_{m=0}^{M} \mathbf{H}_{S_1 R.k.m} \mathbf{x}_{S_1.k-m} + \sum_{m=0}^{M} \mathbf{H}_{S_2 R.k.m} \mathbf{x}_{S_2.k-m} + \mathbf{n}_{SR.k} \qquad k = 1,...,N \qquad (1)$$

Où $\mathbf{n}_{SR.k} \in C^{R_x}$ désigne le vecteur de bruit additif, $\mathbf{H}_{S_1 R} \in C^{R_x \times T_{S1}}$ et $\mathbf{H}_{S_2 R} \in C^{R_x \times T_{S2}}$ désignent les matrices de coefficients d'évanouissement (fading) entre les deux sources et le relais, et M désigne la mémoire du canal (l'effet mémoire du canal est lié au retard de propagation ou delay spread). Ce retard entraîne une superposition des signaux transmis ce qui se traduit par de l'interférence entre les symboles.

Le relais R fait une détection/décodage conjointe 4 des données reçues de façon « dure » ou de façon « souple » au moyen d'un détecteur/décodeur conjoint DET/DEC pour en déduire les vecteurs de valeurs réelles $\lambda_{1R} \in R^K$, $\lambda_{2R} \in R^K$ représentatifs des données binaires des deux sources et il les mémorise.

Le relais applique 5 en même temps à partir des deux vecteurs $\lambda_{1R}$ et $\lambda_{2R}$ correspondant au bloc précédent, une fonction 0, détaillée par la suite, pour obtenir une information de redondance $\mathbf{X}_R = \Theta(\lambda_{1R}, \lambda_{2R}) \in C^{T_R \times N_R}$ qui est émise 6 par le relais à destination du récepteur sur $N_R$ utilisations du canal (intervalles de transmission). Dans ce cas là $N_R = N$.

L'émission par le relais du mot de code supplémentaire $\mathbf{X}_R$ est décalée par rapport à l'émission des mots de code $\mathbf{X}_{S_1}$, $\mathbf{X}_{S_2}$ relatifs à K bits d'information. Un ordonnancement cadence le traitement entre les émetteurs et le relais des mots de code et du mot de code supplémentaire $\mathbf{X}_R$ : dans le cas d'un relais full-duplex, le mot de code supplémentaire $\mathbf{X}_R$ est émis avec un décalage d'un bloc de K bits d'information par rapport aux mots de code $\mathbf{X}_{S_1}$, $\mathbf{X}_{S_2}$ ; le mode de code supplémentaire $\mathbf{X}_R$ émis pendant $N_R = N$ intervalles de transmission est relatif aux mots de code $\mathbf{X}_{S_1}$, $\mathbf{X}_{S_2}$ émis pendant les $N_R = N$ intervalles de transmission qui précèdent.

Ce mot de code supplémentaire $\mathbf{X}_R$ est émis par le relais vers le destinataire D (le récepteur). Le récepteur observe une superposition des symboles transmis provenant des sources et du relais et il exploite ces symboles superposés ainsi qu'éventuellement ceux reçus antérieurement et correspondant à un ou plusieurs blocs précédents de K bits pour récupérer les messages $u_{S_1}$, $u_{S_2}$ relatifs chacun à un bloc de K bits. A cette fin, il effectue une détection/décodage conjointe itérative.

Selon différents modes de réalisation, la topologie de base peut être répétée pour déterminer un système MARC à plusieurs relais et plusieurs destinations, chaque relais étant associé à au moins deux émetteurs et un récepteur. Selon d'autres modes de réalisation, les deux émetteurs d'une topologie de base peuvent ne faire qu'un avec au moins deux antennes d'émission. Dans tous les cas, le relais et le récepteur reçoivent des mots de code transmis via des canaux de transmission distincts.

Chaque relais R fournit donc des mots de code de redondance $\mathbf{X}_R$ qui permettent d'améliorer le décodage au récepteur. Ces mots de code de redondance sont formés en séparant les flux provenant des deux émetteurs puisque les mots de code $\mathbf{Y}_{1R}$, $\mathbf{Y}_{2R}$ provenant des deux émetteurs $S_1$, $S_2$ sont superposés dans un même flux reçu $\mathbf{Y}_R$ du fait des liens S1->R, S2->R non orthogonaux et en codant conjointement les valeurs extraites des flux superposés.

De nombreuses variantes de mises en oeuvre peuvent être envisagées, en fonction du type de codage, de la concaténation des codes (parallèle, série, ou quelconque).

De nombreux types de codes peuvent être utilisés dans les émetteurs et dans les relais, dès lors qu'il s'agit de codes linéaires. Il peut notamment s'agir de :

- codes convolutifs ;
- codes BCH ;
- codes RS ;
- turbo-codes ;
- codes LDPC binaires ou non-binaires ;
- codes de parité.

Il est possible d'utiliser le même code dans les émetteurs et les relais, ou des codes différents.

Selon un premier mode de réalisation, le système MARC illustré par la figure 4 comporte des liens CH1, CH2 entre les sources S1, S2 et le relais R qui sont supposés parfaitement fiables, autrement dit les liens sont de très bonne qualité et le décodage est quasiment sans erreur.

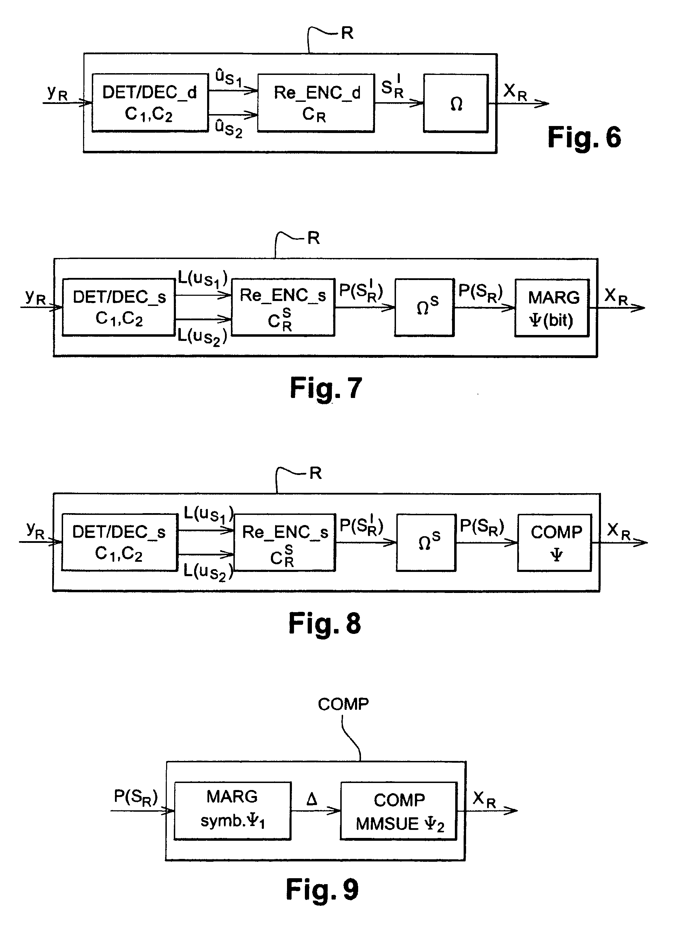

Le relais R, illustré par la figure 6, décode de façon dure les données des deux sources à l'aide d'un détecteur/décodeur conjoint dur DET/DEC_d et il les ré-encode conjointement à l'aide d'un codeur conjoint dur Re_ENC_d à partir du schéma de modulation et de codage espace temps $C_R$.

Les sorties $\hat{\mathbf{u}}_{S_1}$, $\hat{\mathbf{u}}_{S_2}$ du détecteur/décodeur conjoint DET/DEC_d prennent des valeurs binaires exploitées par le codeur conjoint Re_ENC_d :

$$\boldsymbol{\lambda}_{1R} = \hat{\mathbf{u}}_{S_1} \in F_2^K$$

$$\boldsymbol{\lambda}_{2R} = \hat{\mathbf{u}}_{S_2} \in F_2^K$$

Le codeur conjoint dur Re_ENC_d exploite en entrée deux vecteurs de valeurs binaires et produit une matrice de symboles discrets $\mathbf{S}_R^1 \in \chi_R^{T_R \times N_1}$ où $\chi_R$ est une constellation complexe de cardinalité $|\chi_R| = 2^m (m \in \mathbf{N})$ en appliquant le schéma de modulation et de codage espace temps $C_R$ :

$$C_R : F_2^K \times F_2^K \to \chi_R^{T_R \times N_1}$$

qui produit les symboles discrets $\mathbf{S}_R^1 \in \chi_R^{T_R \times N_1}$, Ensuite, une fonction de sélection de colonnes $\Omega$ est appliquée:

$$\Omega : \chi_R^{T_R \times N_1} \to \chi_R^{T_R \times N_0} \quad ,$$

$N_0 \leq N_1$ qui choisit $N_0$ colonnes de la matrice $\mathbf{S}_R^1 \in \chi_R^{T_R \times N_1}$ pour obtenir les symboles de redondances $\mathbf{S}_R \in \chi_R^{T_R \times N_0}$ , telle que $\mathbf{S}_R = \Omega(\mathbf{S}_R^1)$.

Le relais émet ces symboles discrets, éventuellement pondérés en puissance, pendant $N_0 = N_R$ intervalles de transmission. Ces symboles discrets $\mathbf{X}_R$ peuvent être exprimés sous la forme :

$$\mathbf{X}_R = \beta \mathbf{S}_R = \Theta(\hat{\mathbf{u}}_{S_1}, \hat{\mathbf{u}}_{S_2}) \in \chi_R^{T_R \times N_R}$$

où $\beta$ est un facteur de normalisation en puissance et $\Theta$ est une fonction déterministe des données estimées des deux sources.

Selon un deuxième mode de réalisation, le système MARC illustré par la figure 4 comporte des liens CH1, CH2 entre les sources S1, S2 et le relais R avec un évanouissement de Rayleigh. En outre, les sources n'ont pas de connaissance du lien séparant une source du relais. Il existe par conséquent une probabilité non nulle que le relais décode imparfaitement les messages des deux sources. Dans ces conditions, il y a un risque que le relais propage des erreurs vers le destinataire.

Ce mode permet la prise en compte au niveau du destinataire lors du décodage conjoint des erreurs de décodage intervenues au relais.

Selon ce mode, le relais R illustré par les figures 7 et 8 effectue une détection/décodage conjointe souple au moyen d'un détecteur/décodeur conjoint souple DET/DEC_s pour obtenir les probabilités a posteriori (APP) des bits d'information, ($\{P(u_k = 0,1)\}$).

Les APP des bits d'information sont calculées sous forme de rapport de vraisemblance (LLR Log-Likelihood-Ratio) définis comme suit :

$$\left[\lambda_{1R}\right]_k = L(u_{S_i,k}) = \left[\mathbf{L}(\mathbf{u}_{S_i})\right]_k = \ln\frac{P(u_{S_i,k}=1)}{P(u_{S_i,k}=0)} \quad k=1,\cdots,K \quad i=1,2 \, .$$

Ainsi :

$$\lambda_{1R} = \mathbf{L}(\mathbf{u}_{S_1}) \in R^K$$

$$\lambda_{2R} = \mathbf{L}(\mathbf{u}_{S_2}) \in R^K$$

Le relais effectue ensuite un ré-encodage conjoint espace temps de réseau pondéré, à l'aide d'un codeur conjoint Re_ENC_s, détaillé par la suite, à partir du schéma de modulation et de codage $C_R$ :

$$\mathbf{C_R} : F_2^K \times F_2^K \rightarrow \chi_R^{T_R \times N_1}$$

Le codeur exploite deux vecteurs de valeurs binaires et produit une matrice de symboles discrets $\mathbf{S}_R^1$ appartenant à $\chi_R^{T_R \times N_1}$ où $\chi_R$ est une constellation complexe de cardinalité $|\chi_R| = 2^m$ ($m \in \mathbf{N}$).

La fonction d'encodage espace temps de réseau pondéré qui utilise un algorithme BCJR appliqué au code $C_R$ est représentée sous la forme :

$$\mathbf{C_R^S} : R^K \times R^K \rightarrow R^{(|\chi_R|^{T_R}-1)\times N_1}$$

La fonction d'encodage de réseau pondéré, mise en oeuvre par le codeur conjoint Re_ENC_s, exploite deux vecteurs de valeurs réelles (les vecteurs de LLRs des bits décodés), et fournit les probabilités des symboles ($T_R$ dimensionnels) $\mathbf{s}_{R,k}^1 \in \chi_R^{T_R}$ sous la forme de ($2^{mT_R}-1$) LLR :

$$\ln\frac{P(\mathbf{s}_{R,k}^1 = \mathbf{a}_i)}{P(\mathbf{s}_{R,k}^1 = \mathbf{a}_0)}$$

avec $\mathbf{a}_i \in \chi_R^{T_R}$ et $\bigcup_{i=0}^{2^{mT_R}-1} \{\mathbf{a}_i\} = \chi_R^{T_R}$, $i = 1,...,2^{mT_R}-1$, $k = 1,..., N_1$. Soit :

$$P(S_R^1)_{i,k} = \ln \frac{P(s_{R,k}^1 = \mathbf{a}_i)}{P(s_{R,k}^1 = \mathbf{a}_0)}$$

définissant la matrice $P(S_R^1) \in R^{(|\chi_R|^{T_R}-1)\times N_1}$.

A la fin, une fonction de sélection de colonnes $\Omega^S$ (qui supprime toutes les probabilités relatives aux vecteurs supprimés par la fonction de sélection de colonnes $\Omega$) est appliquée à la matrice $P(S_R^1) \in R^{(|\chi_R|^{T_R}-1)\times N_1}$. Ainsi, on définit la fonction :

$$\Omega^S : R^{(|\chi_R|^{T_R}-1)\times N_1} \rightarrow R^{(|\chi_R|^{T_R}-1)\times N_0},$$

$N_0 \leq N_1$ telle que $P(S_R) = \Omega^S\left(P(S_R^1)\right)$

Le relais illustré par la figure 7 correspond à un mode particulier selon lequel le ré-encodage conjoint est suivie d'une marginalisation MARG avant émission de l'information de redondance.

Ce mode particulier est adapté pour un relais dans lequel le schéma de modulation et de codage espace temps $C_R$ est basé sur une fonction de codage binaire (pouvant comprendre un entrelaceur) : $C : F_2^K \times F_2^K \rightarrow F_2^{N_1 \times T_R \times m}$ et sur une modulation (une fonction de codage bit à symbole) associant des bits à des symboles $\varphi_R : F_2^m \rightarrow \chi_R \subseteq C$ ($\subseteq$ signifie "sous ensemble de"), où $\chi_R$ dénote la constellation des symboles obtenus de cardinalité $|\chi_R| = 2^m$, c'est-à-dire que $s_{R,k,t}^1 = \varphi_R(c_{R,k,t(1)}^1, \cdots, c_{R,k,t(m)}^1)$. Un exemple de ce schéma de codage et modulation espace temps est la ST-BICM.

L'opération de marginalisation $\Psi$ consiste à calculer les probabilités au niveau des bits à partir des probabilités des symboles $P(S_{R,k})$ mémorisées sous forme de $P(S_R)_{i,k}$, pour fournir des logarithmes d'un rapport d'APP.

En supposant que $C_R \in F_2^{N_0 \times T_R \times m}$ soit l'information de redondance binaire, $c_{R,k,t(l)} = \varphi_{R(l)}^{-1}(s_{R,k,t})$ dénote le $l^{ème}$ bit du symbole $s_{R,k,t}$ ($k = 1,...,N_0$, $l = 1,...,m$, $t = 1,\cdots,T_R$). L'application de la fonction de marginalisation $\Psi$ décrite par l'expression : $R^{(|\chi_R|^{T_R}-1)\times N_0} \rightarrow R^{T_R \times m \times N_0}$ permet d'obtenir les LLR $L(c_{R,k,t(l)})$ des bits $c_{R,k,t(l)}$ :

$$L(c_{R,k,t(l)}) = \ln\left(\frac{P(c_{R,k,t(l)} = 1)}{P(c_{R,k,t(l)} = 0)}\right)$$

à partir des probabilités :

$$P(c_{R,k,t(l)} = b) = \sum_{\mathbf{a} \in \chi_R^{T_R} : \varphi_l^{-1}(a_l) = b} P(s_{R,k} = \mathbf{a}) \qquad b = 0,1$$

Où :

$$P(s_{R,k} = \mathbf{a}_i) = c_0 e^{P(S_R)_{i,k}} \quad i = 1,\cdots,2^{mT_R}-1 \text{ avec } c_0 = P(s_{R,k} = \mathbf{a}_0) = \frac{1}{1 + \sum_{i=1}^{2^{mT_R}-1} e^{P(S_R)_{i,k}}}$$

Soit la matrice $L(c_R) \in R^{T_R \times mN_0}$ définie comme suit :

$$\left[\mathbf{L}(\mathbf{c}_R)\right]_{t,(k-1)m+l} = L(c_{R.k.t(l)}) \ k = 1,\cdots,N_0, t = 1,\cdots,T_R, l = 1,\cdots,m \quad ,$$

alors l'information de redondance $\mathbf{X}_R = \beta\mathbf{L}(\mathbf{c}_R)$ est émise à destination du récepteur pendant $N_R = mN_0$ intervalles de transmission ($N_R = mN_0/2$ si le procédé utilise la voie en quadrature et en phase) où $\beta$ est un facteur de normalisation en puissance.

Ce mode particulier est applicable à toutes les modulations, mais comme le relais émet les valeurs souples correspondant aux bits sous forme de LLR l'efficacité spectrale est limitée à celle disponible pour la modulation BPSK(ou QPSK).

Le relais illustré par la figure 8 correspond à un mode particulier selon lequel le ré-encodage conjoint est suivie d'une compression COMP avant émission de l'information de redondance. La fonction de compression $\Psi$ peut s'exprimer sous la forme :

$$\Psi : R^{(|\chi_R|^{T_R}-1)\times N_0} \to C^{T_R \times N_0}$$

L'opération de compression de la distribution des probabilités a pour avantage de permettre la transmission de toutes les informations souples concernant les probabilités d'un symbole fournies par l'encodeur sur un seul intervalle de transmission, quelle que soit la modulation du schéma de modulation et de codage $C_R$.

L'exemple suivant correspond au cas particulier d'une compression MMSUE. Le schéma des opérations du relais pour faire la compression MMSUE est illustré par la figure 9.

La fonction de marginalisation au niveau des symboles, $\Psi_1$, représentée par :

$$\Psi_1 : R^{(|\chi_R|^{T_R}-1)\times N_0} \to R^{T_R \times(|\chi_R|-1)\times N_0}$$

exploite les vecteurs des LLRs $\mathbf{P}(\mathbf{S}_R) \in R^{(|\chi_R|^{T_R}-1)\times N_0}$, et fournit les LLRs $\Delta_{t.j.k}$. Soit :

$\Delta \in R^{T_R \times(|\chi_R|-1\times N_0}$ avec

$$\Delta_{t.j.k} = \ln \frac{P(s_{R.k.t} = b_j)}{P(s_{R.k.t} = b_0)}$$

$$b_j \in \chi_R, \bigcup_{i=0}^{2^m-1}\{b_j\} = \chi_R \quad , \quad j = 1,\ldots,2^m-1, k = 1,\ldots N_0, t = 1,\ldots,T_R$$

Où:

$$P(s_{R.k.t} = b_j) = \sum_{i:a_{i,t}=b_j} P(\mathbf{s}_{R.k} = \mathbf{a}_i) = \sum_{i:a_{i,t}=b_j} c_0 e^{P(\mathbf{S}_R)_{i,k}}$$

$$b_j \in \chi_R, j = 0,\ldots,2^m-1 \quad , \quad i = 1,\cdots,2^{mT_R}-1$$

avec :

$$c_0 = P(\mathbf{s}_{R.k} = \mathbf{a}_0) = \frac{1}{1 + \sum_{i=1}^{2^{mT_R}-1} e^{P(\mathbf{S}_R)_{i,k}}}$$

Cette fonction de marginalisation peut être directement intégrée dans l'étape de réencodage/modulation souple.

La fonction de compression MMSUE, $\Psi_2$, consiste à calculer l'espérance des symboles $S_{R,k,t}$ et elle est représentée sous la forme :

$$\Psi_2 : R^{T_R \times (|\chi_R|-1) \times N_0} \to C^{T_R \times N_0}$$

Elle exploite les LLR $\Delta_{r,j,k}$ et calcule :

$$E(s_{R,k,t}) = \sum_{j=0}^{|\chi_R|-1} b_j P(s_{R,k,t} = b_j) = \sum_{j=0}^{|\chi_R|-1} b_j K_0 e^{\Delta_{r,j,k}}$$

avec

$$b_j \in \chi_R, j = 0,\ldots,2^m - 1, \quad K_0 = P(s_{R,k,t} = b_0) = \frac{1}{1 + \sum_{j=1}^{|\chi_R|-1} e^{\Delta_{r,j,k}}}, \quad \Delta_{t,0,k} = 0$$

Les espérances $E(s_{R,k,t})$ calculées sont mémorisées dans une matrice $\mathbf{E}(\mathbf{s}_R) \in C^{T_R \times N_0}$ et l'information de redondance $\mathbf{X}_R = \beta \mathbf{E}(\mathbf{s}_R)$ est envoyée à la destination sur $N_R = N_0$ utilisations du canal où $\beta$ est un facteur de normalisation en puissance.

Dans la suite de la description d'un exemple particulier de mise en oeuvre d'un relais, les sources S1, S2 (les émetteurs) sont supposées mettre en oeuvre des schémas de modulation et codage BICM (Bit Interleaved Coded Modulation), c'est-à-dire que ces schémas comprennent une concaténation série d'un encodeur binaire, d'un entrelaceur bit-à-bit (dénommé entrelaceur du canal) et d'un modulateur. Les émetteurs considérés comprennent donc des entrelaceurs pseudo-aléatoires au niveau du bit, avant la transmission des signaux. Par conséquent, aussi bien le relais que le récepteur comprennent les désentrelaceurs correspondants. Les entrelaceurs sont utilisés pour casser la corrélation entre les bits consécutifs transmis ce qui permet d'effectuer plus efficacement une détection/décodage conjointe itérative.

Pour simplifier les notations, on suppose par la suite qu'une seule antenne d'émission et une seule antenne de réception sont utilisées dans tous les émetteurs et récepteurs, donc, $T_{S_1} = T_{S_2} = R_x = 1$. En outre, il est supposé que les évanouissements de Rayleigh sont quasi statiques, que le canal est sans mémoire et que les récepteurs disposent d'une connaissance parfaite de la variance du bruit et des coefficients d'évanouissement (fading).

Les schémas de codage correspondant aux deux sources, associent à tout vecteur message $\mathbf{u}_{S_1} \in F_2^K$ et $\mathbf{u}_{S_2} \in F_2^K$ des bits codés $\mathbf{c}_{S_1} \in F_2^{n_1}$ et $\mathbf{c}_{S_2} \in F_2^{n_2}$ ($n_1$ et $n_2$: longueurs des bits codés) qui sont entrelacés pour donner $V_{S_1} \in F_2^{N \times p}$ et $V_{S_2} \in F_2^{N \times q}$, puis modulés (à partir des schémas de modulations des deux sources) aux symboles (mots de code) $\mathbf{x}_{S_1} \in \chi_1^N$ et $\mathbf{x}_{S_2} \in \chi_2^N$ qui appartiennent à une constellation complexe. En supposant que les étiquetages utilisés soient $\varphi_1 : \varphi_1 : F_2^p \to \chi_1 \subseteq C$ et $\varphi_2 : F_2^q \to \chi_2 \subseteq C$ où chaque symbole modulé de $S_1$ et $S_2$ appartient respectivement aux ensembles complexes $\chi_1$ et $\chi_2$ de cardinalités $|\chi_1| = 2^p$ et $|\chi_2| = 2^q$ alors $v_{S,k(l)} = \varphi_{i(l)}^{-1}(x_{S,k})$ dénote le $l^{ème}$ bit de l'étiquetage binaire de $x_{S_1,k}$ ($k = 1,\ldots, N$, $l = 1,\ldots, p$ pour $S_1$, et $l = 1,\ldots, q$ pour $S_2$).

Le schéma de codage et modulation correspondant au relais, $C_R$, est basé sur un code binaire $F_2^K \times F_2^K \to F_2^n$ (le vecteur des bits codés des redondances est noté $c_R$, $\mathbf{c}_R \in F_2^{n'}$, $n' < n$), un entrelaceur (les bits codés et entrelacés sont désignés par $V_R \in F_2^{N_R \times m}$), et un modulateur avec un codage bit à symbole $\varphi_R : F_2^m \to \chi_R \subseteq C$, où $\chi_R$ dénote la constellation des symboles obtenus de cardinalité $|\chi_R| = 2^m$. Le signal (mot de code) émis par le relais est dénoté $\mathbf{x}_R \in C^{N_R}$.

Le fonctionnement du relais est décrit ci-après plus en détail.

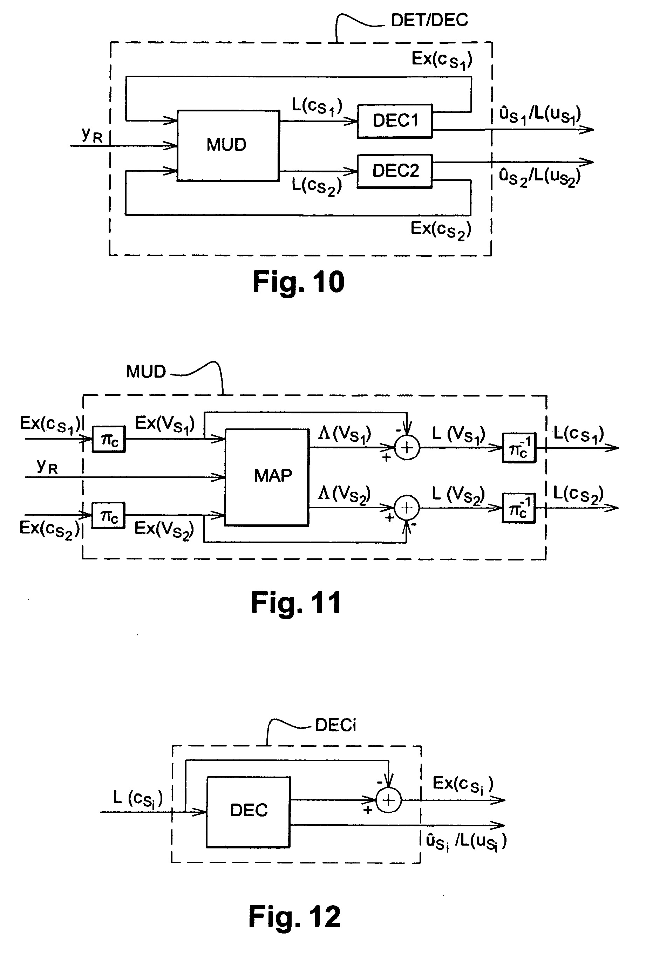

Le détecteur/décodeur conjoint DET/DEC est illustré par la figure 10. La description couvre aussi bien le cas où ce détecteur/décodeur conjoint prend une décision dure qu'une décision souple.

Le détecteur/décodeur conjoint DET/DEC applique un schéma de détection/décodage conjoint de manière itérative. Ce schéma est mis en oeuvre par un détecteur multi utilisateurs MUD suivi de deux décodeurs DEC1 et DEC2 en parallèles.

Le relais R reçoit une superposition des signaux des deux sources S1, S2 exprimée par la relation (1) qui se simplifie dans le cas où le nombre des antennes d'émission des sources et le nombre des antennes de réception du relais est égal à un, dans le cas où il y a des évanouissements de Rayleigh quasi statiques et dans le cas où le canal est sans mémoire :

$$y_{R.k} = y_{1R.k} + y_{2R.k}$$
$$= h_{S_1R} x_{S_1.k} + h_{S_2R} x_{S_2.k} + n_{SR.k} \qquad k = 1,...,N \qquad (2)$$

Où $n_{SR,k}$ désigne le bruit additif gaussien qui a pour distribution $CN(0, \sigma_n^2)$ et où $h_{S_1R}$ et $h_{S_2R}$ désignent les coefficients des liens entre respectivement les sources S1, S2 et le relais R.

A chaque itération, le détecteur multi utilisateur MUD, schématisé à la figure 11, sépare les flux à partir des données reçues $\mathbf{y}_R$, extrait les informations issues de chacune des sources en mettant en oeuvre un détecteur MAP (Maximum a posteriori). Le détecteur MAP calcule les informations souples des bits codés des deux sources, sous la forme d'un rapport logarithmique de probabilité (LLR) $\{\mathbf{L}(\mathbf{c}_{S_1})\}$ et $\{\mathbf{L}(\mathbf{c}_{S_2})\}$, en exploitant l'observation bruitée issue du canal $\mathbf{y}_R$ et les informations a priori sur des bits codés et entrelacés $\{\mathbf{E}x(\mathbf{V}_{S_1})\}$ et $\{\mathbf{E}x(\mathbf{V}_{S_2})\}$ fournies par le décodeur DECi à l'itération précédente.

Le rapport logarithmique de probabilité (LLR) d'un $l$ème bit d'un symbole de chaque source $v_{S_i(l)} = \varphi_{i(l)}^{-1}(x_{S_i})$ est calculé selon les équations suivantes :

(Pour simplifier les notations, les indices de temps sont omis.)

$$\Lambda(v_{S_i(l)}) = \log \frac{P(v_{S_i(l)} = 1 \mid y_R)}{P(v_{S_i(l)} = 0 \mid y_R)}$$
$$= \log \frac{\sum_{x_i \in \chi_i: \varphi_{i(l)}^{-1}(x_i)=1} \sum_{x_j \in \chi_j} p(y_R \mid x_{S_i} = x_i, x_{S_j} = x_j) e^{\xi(x_i)+\xi(x_j)}}{\sum_{x_i \in \chi_i: \varphi_{i(l)}^{-1}(x_i)=0} \sum_{x_j \in \chi_j} p(y_R \mid x_{S_i} = x_i, x_{S_j} = x_j) e^{\xi(x_i)+\xi(x_j)}} \qquad (3)$$

$$(i, j = 1,2 \text{ et } i \neq j)$$

Connaissant la distribution gaussienne du bruit, ceci permet d'écrire :

$$\Lambda(v_{S_i(l)}) = \log \left( \frac{\sum_{x_i \in \chi_i: \varphi_{i(l)}^{-1}(x_i)=1} \sum_{x_j \in \chi_j} \exp\left(-\left\|\frac{y_R - h_{S_iR} x_i - h_{S_jR} x_j}{\sigma_n}\right\|^2 + \xi(x_i) + \xi(x_j)\right)}{\sum_{x_i \in \chi_i: \varphi_{i(l)}^{-1}(x_i)=0} \sum_{x_j \in \chi_j} \exp\left(-\left\|\frac{y_R - h_{S_iR} x_i - h_{S_jR} x_j}{\sigma_n}\right\|^2 + \xi(x_i) + \xi(x_j)\right)} \right) \qquad (4)$$

Où:

$$\xi(x_i) = \sum_{l'=1}^{\log_2|\chi_i|} \varphi_{i(l')}^{-1}(x_i) Ex(v_{S_i(l')}) \qquad (5)$$

$$\xi\left(x_j\right) = \sum_{l'=1}^{\log_2|x_j|} \varphi_{j(l')}^{-1}(x_j) E_x(v_{S_i(l')}) \qquad (6)$$

$$(i, j = 1,2 , \ i \neq j \ \text{et} \ l' \neq l )$$

Où $\{Ex(v_{S_1(l)})\}$ sont les rapports logarithmiques des probabilités a priori sur les bits de chaque symbole, fournis par le décodeur à l'itération précédente.

Les rapports logarithmiques des probabilités (LLR) extrinsèques à la sortie du détecteur MAP sont calculés selon :

$$L(v_{S_i(l)}) = \Lambda(v_{S_i(l)}) - E_x(v_{S_i(l)}) \qquad (7)$$

Après desentrelacement effectué par un desentrelaceur $\pi_c^{-1}$ qui effectue la fonction inverse de l'entrelaceur utilisé à l'émission en association avec le codage de canal, le MUD fournit les rapports logarithmiques des probabilités (LLR) extrinsèques sur les bits codés $L(c_{S_i})$.

A chaque itération, les décodeurs DECi, schématisés à la figure 12, utilisent respectivement les vecteurs des rapports logarithmiques de probabilités (LLR) intrinsèques des bits codés $\{L(c_{S_1})\}$ et $\{L(c_{S_2})\}$ fournis par le MUD. Ils délivrent des rapports logarithmiques de probabilités extrinsèques $\{Ex(c_{S_1})\}$ et $\{Ex(c_{S_2})\}$ sur les bits codés $c_{S_1}$ et $c_{S_2}$. Après entrelacement, les rapports logarithmiques de probabilités extrinsèques $Ex(V_{S_1})$ et $Ex(V_{S_2})$ sur les bits codés et entrelacés sont exploités à l'itération suivante par le MUD comme des rapports logarithmiques de probabilités a priori. L'entrelaceur est identique à celui utilisé à l'émission en association avec le codage de canal.

A la dernière itération, chaque décodeur DECi prend une décision dure/souple et fournit un vecteur $\hat{u}_{S_i}$ /$L(u_{S_i})$ représentatif des K bits d'information $u_{S_i}$.

Dans le mode full duplex, en même temps que le relais effectue la détection/décodage du bloc reçu, il émet à destination du récepteur le signal déduit du bloc précédent. Par conséquent, la destination observe une superposition des informations émanant des deux sources et de l'information codée du bloc précédent émanant du relais. Ceci est un schéma de codage général utilisé dans les canaux à relais, à savoir, un codage de superposition du bloc de Markov.

Le signal reçu à la destination D contenant une information émanant du relais concernant le bloc d'information précédent, le traitement à la réception doit exploiter conjointement plusieurs blocs successifs. Le signal reçu peut s'exprimer sous la forme :

$$y_{D,k}^i = h_{S_1D}^i x_{S_1,k}^i + h_{S_2D}^i x_{S_2,k}^i + h_{RD}^i x_{R,k}^i + n_k^i \qquad \begin{matrix} k = 1,...,N \\ i = 0,...,B \end{matrix} \qquad (8)$$

Où $B$ désigne le nombre des blocs d'informations considérés ($B$ blocs, chacun correspondant à K bits d'information), $\mathbf{x}_{S_1}^i$ et $\mathbf{x}_{S_2}^i$ sont les mots de code modulés émis respectivement par les sources S1 et S2 correspondant aux mots d'information $\mathbf{u}_{S_1}^i$ et $\mathbf{u}_{S_2}^i$, et $\mathbf{x}_R^i$ est un vecteur de redondance, émis par le relais, des messages précédents $\mathbf{u}_{S_1}^{i-1}$ et $\mathbf{u}_{S_2}^{i-1}$ .

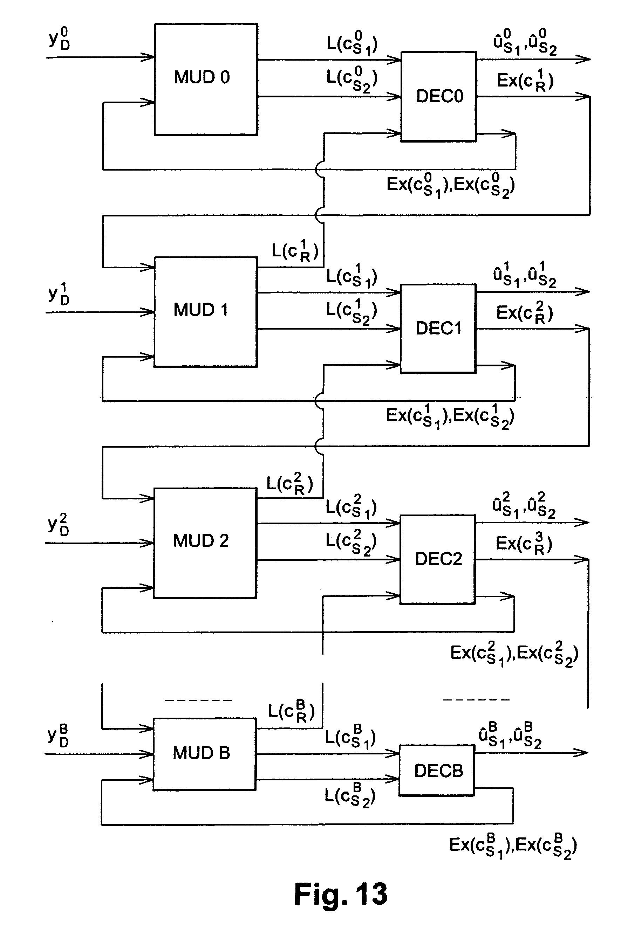

Après réception de $B+1$ blocs, le récepteur D détecte et décode les informations des deux sources à l'aide d'un algorithme itératif de détection/décodage conjoint. Cet algorithme est illustré par la figure 13. Par souci de simplicité, les entrelaceurs du canal ne sont pas représentés.

Les B+1 détecteurs multi utilisateurs MUDi permettent d'obtenir les LLR des mots de code reçus émanant des deux sources et du relais. Ces LLR sont exploités par les $B+1$ décodeurs DECi.

Le décodeur i DECi exploite en entrée des rapports logarithmiques de probabilités intrinsèque des bits codés $\left\{\mathbf{L}(\mathbf{c}_{S_1}^i)\right\}$, $\left\{\mathbf{L}(\mathbf{c}_{S_2}^i)\right\}$ et $\left\{\mathbf{L}(\mathbf{c}_R^{i+1})\right\}$ fournis par le MUD i et le MUD $i+1$ et il détermine des rapports logarithmiques de probabilités extrinsèques $\left\{\mathbf{E_x}(\mathbf{c}_{S_1}^i)\right\}$, $\left\{\mathbf{E_x}(\mathbf{c}_{S_2}^i)\right\}$ et $\left\{\mathbf{E_x}(\mathbf{c}_R^{i+1})\right\}$ sur les bits codés $\mathbf{c}_{S_1}^i$, $\mathbf{c}_{S_2}^i$ et $\mathbf{c}_R^{i+1}$. Ces valeurs, après entrelacement, sont exploitées en entrée par les mêmes MUD comme des valeurs a priori. Le dernier bloc est traité avec une légère modification puisqu'il n'y a pas pour celui-ci de vecteur de redondance déterminé par le relais.

La détermination du nombre de blocs B considérés dépend de l'implémentation du système MARC.

Selon un premier mode de réalisation, les sources S1, S2 émettent une trame de B+1 blocs. Le B+1ième bloc ne bénéficie pas à la destination du codage réseau. Le décodage de ce bloc est de moins bonne qualité que le décodage des autres B blocs. Le rapport du nombre de bloc avec des performances dégradées est de 1/B+1, plus B est grand plus les performances seront meilleurs. Il y a donc avantage à déterminer un nombre B le plus grand possible pour minimiser la perte de qualité sur le décodage. Mais plus le nombre B est grand, plus la complexité du traitement à la réception augmente.

Selon un deuxième mode de réalisation, chaque source transmet ses informations en trame de B blocs consécutifs (B0,...B-1), chaque bloc durant N intervalles de transmission. Le récepteur décode conjointement ces blocs après réception du mot de code de redondance émis par le relais concernant le bloc B-1. L'ordonnancement est tel que le bloc B0 est émis en l'absence d'émission simultanée par le relais d'un mot de code de redondance et le mot de code de redondance relatif au bloc B-1 est émis par le relais en l'absence d'une émission simultanée par les sources. L'avantage de ce mode est que tous les blocs décodés bénéficient d'un codage de réseau mais ceci est au détriment de l'efficacité spectrale correspondant au rapport B/B+1 puisque l'émission par le relais du dernier vecteur de redondance relatif aux blocs B-1 doit correspondre à un intervalle de non émission/silence (Guard interval) imposé aux deux sources. Plus B est grand, plus ce rapport se rapproche de un mais plus le traitement à la réception est complexe.

La valeur de B est donc le résultat d'un compromis entre performance de décodage et complexité.

La description suivante est relative à un exemple de mise en oeuvre d'un procédé de transmission et d'un procédé de réception selon l'invention, par un système MARC particulier.

Le système MARC comprend un relais full-duplex qui met en oeuvre un schéma de codage/décodage spécifique du type turbo code distribué. Les deux sources encodent les données par bloc de longueur K avec un même type de codeur convolutif systématique récursif (RSCC) de rendement ½ et émettent les bits systématiques et les bits de parité à destination du relais et du destinataire (récepteur). Dans ce cas : $N = 2K$.

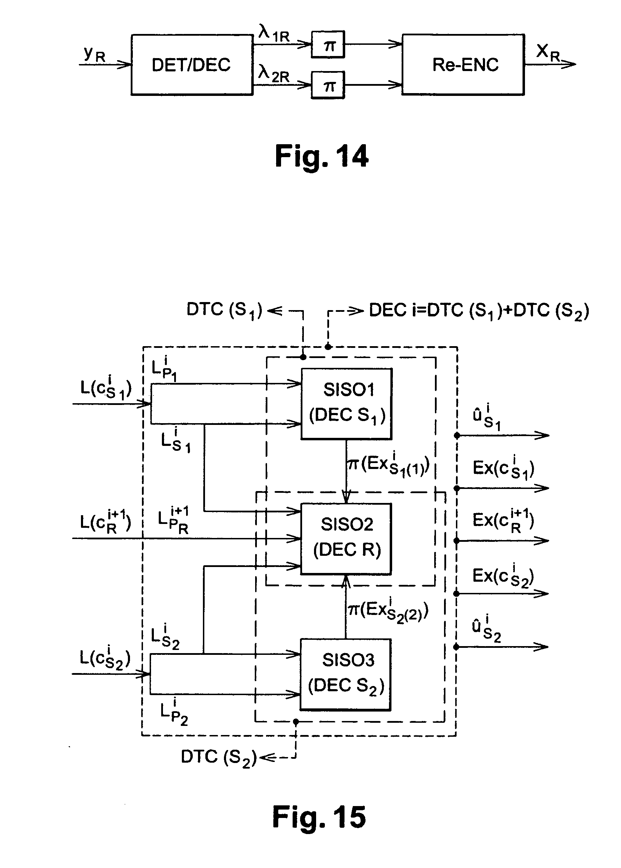

En même temps que le relais reçoit ces flux, il émet à destination du récepteur des séquences de parités supplémentaires qui correspondent au bloc précédent. A cette fin, il entrelace au moyen d'un entrelaceur $\Pi$ les flux décodés du bloc précédent, il les ré-encode conjointement par un codeur RSCC de rendement 2/4 et il émet uniquement les bits de parité. Cette détermination est illustrée par la figure 14.

Ainsi, le destinataire dispose de deux turbo codes distribués (DTC) de rendement ¼, donc très puissants, pour le décodage des paquets d'information $\mathbf{u}_{S_1}^{i-1}$ et $\mathbf{u}_{S_2}^{i-1}$ à l'instant i.

Le relais met en oeuvre un traitement conforme au troisième mode de réalisation préalablement décrit en regard de la figure 8 : le relais prend des décisions souples lors du décodage et du ré-encodage et effectue une compression des distributions de probabilité à la sortie de l'encodeur souple en calculant l'espérance mathématique des symboles.

A la destination, le procédé de réception applique un modèle gaussien pour modéliser la perturbation totale sur le signal reçu provenant du relais.

Pour maximiser le SNR (Signal Noise Ratio ou rapport signal à bruit) à la destination, le système MARC utilise un critère MMSUE (Minimum Mean Squared Uncorrelated Error) : le relais fait une estimation optimale à partir des probabilités à posteriori. Ce choix de critère permet d'optimiser le rôle du relais. Le principe de la compression MMSUE effectuée par le relais est le suivant.

Le relais génère des probabilités sur les symboles $s_{R,k}$ $k = 1,..., N_R$ appartenant à la constellation $\chi_R$ : $\varphi_R : F_2^m \to \chi_R \subseteq C$, où chaque symbole modulé appartient à l'ensemble complexe $\chi_R$ de cardinalité $|\chi_R| = 2^m$.

Donc, $v_{R,k(l)} = \varphi_{R(l)}^{-1}(s_{R,k})$ $k =1,..., N_R$, $l = 1,..., m$ dénote le $l$ème bit de l'étiquetage binaire de $s_{R,k}$. L'énergie des symboles est normalisée à 1 pour simplifier les notations.

Le relais émet des informations sur les paquets des noeuds $S_1$ et $S_2$ encodées et modulées avec $C_R$ sur $N_R$ intervalles de transmission. Les symboles complexes suivants sont émis par le relais pendant les $N_R$ intervalles de transmission :

$$x_{R,k} = f(s_{R,k}) = \sqrt{\frac{P_R}{\sigma_{\tilde{s}_{R.k}}^2}}\,\tilde{s}_{R,k}, \qquad k = 1,..., N_R \qquad (9)$$

avec

$$\tilde{s}_{R,k} = \sum_{a \in \chi_R} s_{R,k} P(s_{R,k} = a) \qquad (10)$$

et

$$\sigma_{\tilde{s}_R}^2 = \frac{1}{N_R} \sum_{k=1}^{N_R} \left| \tilde{s}_{R,k} \right|^2 \qquad (11)$$

Où $P_R$ est l'énergie disponible au relais.

Au récepteur, dans le cas particulier d'un canal gaussien sans interférence, les symboles $x_{R,k}$ sont détectés au sens de l'erreur quadratique moyenne pour obtenir les estimées $\hat{x}_{R,k} = x_{R,k} + n_k$ où $n_k$ est supposé Gaussien de variance connue $\sigma^2$, selon une première approximation gaussienne.

En généralisant le concept de MMSUE (minimum mean squared uncorrelated error) à des données codées, les estimées $\hat{x}_{R,k}$ peuvent s'exprimer sous la forme :

$$\begin{aligned}
\hat{x}_{R,k} &= x_{R,k} + n_k \\
&= \frac{\sigma_{\tilde{s}_R}}{\sigma_{\tilde{s}_R}^2} \sqrt{P_R} (s_{R,k} + e_k) + n_k \\
&= \sigma_{\tilde{s}_R} \sqrt{P_R} s_{R,k} + \sigma_{\tilde{s}_R} \sqrt{P_R} e_k + n_k \\
&= \sigma_{\tilde{s}_R} \sqrt{P_R} s_{R,k} + n_k'
\end{aligned} \qquad (12)$$

la variance de $n_k'$ étant $\sigma^2 + P_R \left( 1 - \sigma_{\tilde{s}_R}^2 \right)$

Une deuxième approximation gaussienne sur $n_k'$, permet de retrouver les probabilités $P(s_{R,k} = a)$, $a \in \chi_R$, proportionnelles à :

$$e^{-\dfrac{\left| \hat{x}_{R,k} - \sigma_{\tilde{s}_R} \sqrt{P_R} s_{R,k} \right|^2}{\sigma^2 + P_R \left( 1 - \sigma_{\tilde{s}_R}^2 \right)}} \qquad (13)$$

Par hypothèse, les noeuds du réseau distribué sont supposés connaître leur puissance d'émission respective.

Pour chaque bloc i, le récepteur utilise un détecteur MAP pour séparer les trois flux et calculer les rapports logarithmiques de probabilités sur les bits codés. Le principe du fonctionnement d'un détecteur MAP a été décrit en regard de la figure 11 pour séparer deux flux. Il doit être adapté pour séparer trois flux. En outre, la compression MMSUE doit être considéré dans les calculs. Le signal reçu par le récepteur s'exprime sous la forme :

$$\begin{aligned}
y_{D,k}^i &= h_{S_1 D}^i x_{S_1,k}^i + h_{S_2 D}^i x_{S_2,k}^i + h_{RD}^i x_{R,k}^i + n_k^i \\
&= h_{S_1 D}^i x_{S_1,k}^i + h_{S_2 D}^i x_{S_2,k}^i + h_{RD}^i \left( \sigma_{\tilde{s}_R^i} \sqrt{P_R} (s_{R,k}^i + e_k^i) \right) + n_k^i \qquad (14) \\
&= h_{S_1 D}^i x_{S_1,k}^i + h_{S_2 D}^i x_{S_2,k}^i + h_{RD}^i \sigma_{\tilde{s}_R^i} \sqrt{P_R} s_{R,k}^i + n_k''^i
\end{aligned}$$

$$i = 0, \ldots, B, k = 1, \ldots, 2K$$

Où:

$$n_k''^i = h_{RD}^i \sigma_{\tilde{s}_R^i} \sqrt{P_R} e_k^i + n_k^i \tag{15}$$

est le bruit équivalent à la destination de moyenne nulle et de variance $\sigma_{n''^i}^2$ :

$$\sigma_{n''^i}^2 = \sigma_{n^i}^2 + P_R \left| h_{RD}^i \right|^2 (1 - \sigma_{\tilde{s}_R^i}^2) \tag{16}$$

Pour chaque bloc i, la sortie du détecteur multi utilisateurs MUD correspondant au flux émanant du relais peut être exprimée sous la forme :

(Pour simplifier les notations, les indices de temps sont omis.)

$$\Lambda(v_{R(l)}^i) = \log\left( A/B \right) \tag{17}$$

avec :

$$A = \sum_{s_R \in \chi_R : \varphi_{R(l)}^{-1}(s_R) = 1} C \tag{18}$$

$$C = \sum_{x_1 \in \chi_1, x_2 \in \chi_2} \exp\left( - \left\| \frac{y_D^i - \sum_{j=1}^{2} h_{s_j D}^i x_j - h_{RD}^i \sigma_{\tilde{s}_R^i} \sqrt{P_R} s_R}{\sigma_{n''^i}} \right\|^2 + \sum_{j=1}^{2} \xi(x_j) + \xi(s_R) \right)$$

$$\tag{19}$$

$$B = \sum_{s_R \in \chi_R : \varphi_{R(l)}^{-1}(s_R) = 0} C \tag{20}$$

Où:

$$\xi\left( x_j \right) = \sum_{l'=1}^{\log_2 |\chi_j|} \varphi_{j(l')}^{-1}(x_j) E_x(v_{S_j(l')}^i) \tag{21}$$

$$\xi\left( s_R \right) = \sum_{l'=1}^{\log_2 |\chi_R|} \varphi_{R(l')}^{-1}(s_j) E_x(v_{R(l')}^i) \tag{22}$$

D'ou le LLR extrinsèque en sortie du MAP du détecteur i :

$$L(v^i_{R(l)}) = \Lambda(v^i_{R(l)}) - Ex(v^i_{R(l)}) \qquad\qquad (23)$$

Après desentrelacement, les valeurs $L(c^i_R)$ sont obtenues en sortie du MUDi.

Le MUDi permet d'obtenir de manière identique, les rapports logarithmiques des probabilités extrinsèques (LLR) sur les bits codés de chaque symbole correspondant aux flux émanant des sources $L(c^i_{S_1})$ et $L(c^i_{S_2})$.

Le principe de la détection/décodage conjoint est illustré de manière détaillée par la figure 15 sur laquelle les informations a priori provenant de l'itération i-1 sont omises. Ce schéma représente en détail le DECi qui est constitué de trois décodeurs à entrées souples et sorties souples (SISO).

Soient $\mathbf{L}^i_{S_1}$ l'information souple des bits systématiques des deux sources et $\mathbf{L}^i_{P_1}$, $\mathbf{L}^{i+1}_{P_R}$ les informations souples des bits de parité correspondant aux deux sources et au relais fournies par les MUD i et i+l (j=1,2).

Soient $\mathbf{Ex}^i_{S_l(k)}$, $\mathbf{Ex}^i_{P_l(k)}$ et $\mathbf{Ex}^{i+1}_{P_R(k)}$ les informations extrinsèques générées par les décodeurs à entrées souples et sorties souples, SISO $k(k = 1,...,3)$.

Selon le mode de réalisation décrit, tous les MUD*i* sont implémentés en parallèle ainsi que les décodeurs DEC*i* comme illustré par la figure 13. Les modules d'une paire de détection/décodage comprenant un MUD*i* et un décodeur DEC*i* fonctionnent en série et ils échangent au sein d'une paire et entre paires des informations souples selon le déroulement suivant :

1. Les MUDi déterminent les rapports logarithmiques de probabilités intrinsèques en utilisant les informations a priori provenant des *B+1* décodeurs DEC*i*. Deux MUD consécutifs i et *i+1* participent au décodage du bloc i de chaque source. Ces MUD exploitent en entrée respectivement (après ré-entrelacement) $\mathbf{Ex}^i_{S_1(1)} + \Pi^{-1}(\mathbf{Ex}^i_{S_1(2)})$ , $\mathbf{Ex}^i_{P_1(1)}$, $\mathbf{Ex}^i_{S_2(3)} + \Pi^{-1}(\mathbf{Ex}^i_{S_2(2)})$ , $\mathbf{Ex}^i_{P_2(3)}$ et $\mathbf{Ex}^{i+1}_{P_R(2)}$ comme valeurs a priori provenant du décodeur DEC*i* avec $\Pi^{-1}(.)$ la sortie d'un desentrelaceur du relais.

2. Les B+1 décodeurs DEC*i* comprennent trois décodeurs SISO1, SISO2, SISO3 à entrée souples et sorties souples. Les décodeurs SISO1 et SIS02 forment un premier turbo décodeur distribué DTC ($S_1$) et les décodeurs SIS02 et SIS03 forment un second turbo décodeur distribué DTC ($S_2$). Les décodeurs DEC*i* fonctionnent en parallèle. Le procédé de calcul mis en oeuvre par un décodeur DEC*i*, illustré par la figure 15, se déroule de manière itérative et par itération, le fonctionnement est le suivant :

- Le décodeur DEC*i*, exploite en entrée les LLR $\{L(c^i_1)\}$, $\{L(c^i_2)\}$ et $\{L(c^{i+1}_R)\}$ issus des MUD i et *i+l*,

- les décodeurs SISO1 et SISO3 fonctionnent simultanément :

   - SISOI exploite en entrée comme information a priori $L^i_{S_1}$, $L^i_{P_1}$ et $\Pi^{-1}(\mathbf{Ex}^i_{S_1(2)})$ obtenues à l'itération précédente, et calcule au moyen d'un algorithme BCJR $\mathbf{Ex}^i_{S_1(1)}$ et $\mathbf{Ex}^i_{P_1(1)}$,

   - SISO3 exploite en entrée comme information a priori $L^i_{S_2}$ et $L^i_{P_2}$ et $\Pi^{-1}(\mathbf{Ex}^i_{S_2(2)})$ obtenues à l'itération précédente, et calcule au moyen d'un algorithme BCJR $\mathbf{Ex}^i_{S_2(3)}$ et $\mathbf{Ex}^i_{P_2(3)}$ ,

   - SIS02 exploite en entrée comme information a priori $L^i_{S_1}$, $L^i_{S_2}$, et $\mathbf{L}^{i+1}_{P_R}$ , $\Pi(\mathbf{Ex}^i_{S_2(3)})$ et $\Pi(\mathbf{Ex}^i_{S_1(1)})$ , et calcule au moyen d'un algorithme BCJR $\mathbf{Ex}^i_{S_1(2)}$ , $\mathbf{Ex}^i_{S_2(2)}$ et $\mathbf{Ex}^{i+1}_{P_R(2)}$.

Apres quelques itérations, les décodeurs DECi prennent des décisions dures sur chaque bloc *i* :

$$\mathbf{L}^i_{S_1} + \mathbf{Ex}^i_{S_1(1)} + \Pi^{-1}(\mathbf{Ex}^i_{S_1(2)})$$

et

$$\mathbf{L}^i_{S_2} + \mathbf{Ex}^i_{S_2(3)} + \Pi^{-1}(\mathbf{Ex}^i_{S_2(2)})$$

pour fournir respectivement $\hat{\mathbf{u}}_{S_1}^i$ et $\hat{\mathbf{u}}_{S_2}^i$.

Selon une utilisation particulière, les deux sources correspondent à deux utilisateurs différents, par exemple deux terminaux mobiles. Selon une autre utilisation, les deux sources peuvent correspondre à deux services différents accessibles depuis un même terminal mais dans ce cas, le terminal est équipé d'au moins deux antennes qui déterminent deux canaux de propagation différents entre le terminal et le relais et entre le terminal et la destination.

[1] C. Hausl, F. Schrenckenbach, I. Oikonomidis, G. Bauch, "Iterative network and channel coding on a Tanner graph," Proc. Annual Allerton Conference on Communication, Control and Computing, Monticello, IL, 2005.

[2] C. Hausl, P. Dupraz, "Joint Network-Channel Coding for the Multiple-Access Relay Channel," Proc. IEEE SECON'06, Reston, VA, Sept. 2006.

[3] S. Yang, R. Koetter, "Network coding over a noisy relay: A belief propagation approach", Proc. IEEE ISIT'07, Nice, France, June 2007.

[4] L.Bahl, J.Cocke, F.Jelinek, and J.Raviv, "Optimal Decoding of Linear Codes for minimizing symbol error rate", IEEE Transactions on Information Theory, vol. IT-20(2), pp.284-287, March 1974.

[5] Tuyen Bui, Jinhong Yuan, "Iterative approaches of cooperative transmission based on superposition modutation", international symposium on communications and information technologies, 2007, pages 1423-1428.

## Revendications

1. Procédé (1) de transmission d'un signal numérique destiné à un réseau à au moins quatre noeuds comprenant deux émetteurs, un relais et un récepteur séparés entre eux par des liens mettant en oeuvre un code de réseau spatialement distribué, comprenant :

   - une étape (2) de codage par émetteur selon un schéma de modulation et de codage ($C_1$, $C_2$), délivrant un mot de code ($X_{S1}$, $X_{S2}$) par bloc de K bits d'information,
   - une étape (3) d'émission dans les deux émetteurs respectivement des deux mots de code,

   **caractérisé en ce que** les liens étant non orthogonaux l'émission dans les deux émetteurs est simultanée pendant N intervalles de transmission et le procédé comprend en outre :

   - une étape (4) dans le relais de détection conjointe pour séparer les flux provenant des deux émetteurs et de décodage souple pour déterminer, par flux, un vecteur de probabilités a postériori des bits décodés du mot de code reçu, la détection et le décodage échangeant de manière itérative des informations souples représentatives des mots de code reçus,
   - une étape (5) dans le relais, de codage souple conjoint de deux vecteurs de probabilités a postériori issus respectivement de deux flux représentatifs de deux mots de code émis, selon un schéma de modulation binaire à symboles et de codage $C_R$ pour produire une matrice de probabilités a postériori des symboles, de détermination à partir de cette matrice d'une matrice des espérances des symboles déterminées selon l'expression :

$$E(s_{R,k,t}) = \sum_{j=0}^{|\chi_R|-1} b_j P(s_{R,k,t} = b_j),$$

   avec $b_j \in \chi_R$, $j=0,...,2^m-1$, $\chi_R$ la constellation des symboles associée à la modulation binaire à symbole de cardinalité $|\chi_R|=2^m$, $k=1,...,N$, $t=1,...,T_R$, $T_R$ le nombre d'antennes d'émission du relais, $P(s_{R,k,t}=b_j)$ les probabilités a postériori des symboles, et de détermination d'une information de redondance à partir de la matrice des espérances,
   - une étape (6) d'émission, par le relais, de l'information de redondance pendant N intervalles de transmission,
   - un ordonnancement dans le relais tel que l'information de redondance émise pendant N intervalles de transmission correspond aux mots de code émis pendant les N intervalles de transmission précédents.

2. Procédé (1) selon la revendication 1, comprenant en outre un ordonnancement dans chaque émetteur tel que l'émetteur n'émet pas de mot de code pendant N intervalles de transmission après avoir émis B mots de code, B étant un paramètre.

3. Programme d'ordinateur sur un support d'informations, ledit programme comportant des instructions de programme adaptées à la mise en oeuvre d'un procédé de transmission d'un signal numérique selon l'une quelconque des revendications 1 à 2, lorsque ledit programme est chargé et exécuté dans un système MARC destiné à mettre en oeuvre le procédé de transmission.

4. Support d'informations comportant des instructions de programme adaptées à la mise en oeuvre d'un procédé de transmission d'un signal numérique selon l'une quelconque des revendications 1 à 2, lorsque ledit programme est chargé et exécuté dans un système MARC destiné à mettre en oeuvre le procédé de transmission.

5. Relais (R) destiné à un système MARC pour la mise en oeuvre d'un procédé de transmission selon l'une quelconque des revendications 1 à 2, **caractérisé en ce qu'**il comprend :

- un moyen de détection conjointe (MUD) pour séparer les flux provenant de deux émetteurs du système MARC et un moyen de décodage souple comprenant deux décodeurs (DEC1, DEC2) en parallèle pour déterminer à partir de deux flux respectivement deux vecteurs de probabilités a postériori de bits décodés représentatifs chacun de K bits d'information associés à un mot de code émis par un émetteur et reçu par le relais, le moyen de détection et le moyen de décodage échangeant de manière itérative des informations souples représentatives des mots de code reçus,
- un moyen de codage souple conjoint (Re_ENC) des deux vecteurs de probabilités a postériori issus respectivement de deux flux représentatifs de deux mots de code émis selon un schéma de modulation binaire à symbole et de codage $C_R$ pour produire une matrice de probabilités a postériori des symboles, un moyen de détermination à partir de cette matrice d'une matrice des espérances des symboles déterminées selon l'expression :

$$E(s_{R,k,t}) = \sum_{j=0}^{|\chi_R|-1} b_j P(s_{R,k,t} = b_j),$$

avec $b_j \in \chi_R$, $j=0,...,2^m-1$, $\chi_R$ la constellation des symboles associée à la modulation binaire à symbole de cardinalité $|\chi_R| = 2^m$, $k=1,...,N$, $t=1,\cdots,T_R$, $T_R$ le nombre d'antennes d'émission du relais, $P(s_{R,k,t} = b_j)$ les probabilités a postériori des symboles,
et un moyen de détermination d'une information de redondance à partir de la matrice des espérances,
- un moyen pour émettre l'information de redondance,
- un moyen d'ordonnancement pour émettre pendant N intervalles de transmission une information de redondance qui corresponde aux mots de code reçus pendant les N intervalles de transmission précédents.

6. Système (SYS) MARC dans lequel le relais est selon la revendication 5.

7. Procédé de réception adapté à un récepteur d'un système MARC adapté pour mettre en oeuvre un procédé de transmission selon l'une des revendications 1 à 2, **caractérisé en ce qu'**il comprend :

- une étape de mémorisation dans B+1 blocs, de données reçues correspondant à des paires de B+1 mots de code émises simultanément respectivement par les deux émetteurs chacune pendant N intervalles de transmission, un mot de code codant un bloc de K bits d'information, données reçues auxquelles sont associées B informations de redondance émises par le relais chacune pendant N intervalles de transmission telles que l'information de redondance émise pendant N intervalles de transmission correspond aux deux mots de code émis simultanément pendant les N intervalles de transmission précédents, B étant un paramètre,
- une étape de détection conjointe et de décodage, en parallèle sur les B+1 blocs de données reçues, pour détecter et séparer à partir du premier bloc les flux provenant des émetteurs et pour détecter et séparer à partir des B blocs suivants les flux provenant des émetteurs et du relais, et pour déterminer pour chacun des B premiers blocs deux vecteurs représentatifs chacun de K bits d'information associés respectivement à deux mots de code en décodant simultanément les flux provenant des émetteurs détectés et séparés à partir d'un même bloc et le flux de redondance associé provenant du relais détecté et séparé lors de la détection conjointe du bloc suivant, un échange d'informations souples représentatives des mots de code intervenant de manière itérative entre détection et décodage d'un même bloc et un échange d'informations souples représentatives d'une information de redondance intervenant de manière itérative entre détection d'un bloc i+1 et décodage d'un bloc i, cette information de redondance étant associée aux mots de code du bloc i, $1 \leq i \leq B$.

**8.** Procédé de réception adapté à un récepteur d'un système MARC adapté pour mettre en oeuvre un procédé de transmission selon l'une des revendications 1 à 2, **caractérisé en ce qu'**il comprend :

- une étape de mémorisation dans B+1 blocs, de données reçues correspondant à des paires de B mots de code émises simultanément respectivement par les deux émetteurs, chaque bloc étant émis pendant N intervalles de transmission, un mot de code codant un bloc de K bits d'information, données reçues auxquelles sont associées B informations de redondance émises par le relais chacune pendant N intervalles de transmission telles que l'information de redondance émise pendant N intervalles de transmission correspond aux deux mots de code émis simultanément pendant les N intervalles de transmission précédents, le bloc B+1 mémorisant uniquement une information de redondance correspondant au bloc précédent de données, B étant un paramètre,
- une étape de détection conjointe et de décodage, en parallèle sur les B+1 blocs pour détecter et séparer à partir du premier bloc les flux provenant des émetteurs, pour détecter et séparer à partir des B-1 blocs suivants les flux provenant des émetteurs et du relais et pour détecter à partir du bloc B+1 le flux provenant du relais et pour déterminer en parallèle pour chacun des B premiers blocs deux vecteurs représentatifs chacun de K bits d'information associés à un mot de code en décodant simultanément les flux provenant des émetteurs séparés à partir d'un même bloc et le flux de redondance associé provenant du relais et séparé lors de la détection conjointe du bloc suivant, un échange d'informations souples représentatives des mots de code intervenant de manière itérative entre détection et décodage d'un même bloc et un échange d'informations souples représentatives d'une information de redondance intervenant de manière itérative entre détection d'un bloc i+1 et décodage d'un bloc i, cette information de redondance étant associée aux mots de code du bloc i, $1 \leq i \leq B$.

**9.** Récepteur adapté pour un système MARC adapté pour mettre en oeuvre un procédé de transmission selon l'une des revendications 1 à 2, **caractérisé en ce qu'**il comprend

- un moyen pour mémoriser B+1 blocs de données reçues correspondant à des paires de B+1 mots de code émises simultanément respectivement par les deux émetteurs, chaque mot de code étant émis pendant N intervalles de transmission, un mot de code codant un bloc de K bits d'information, données reçues auxquelles sont associés B informations de redondance émises par le relais chacune pendant N intervalles de transmission telles que l'information de redondance émise pendant N intervalles de transmission correspond aux deux mots de code émis simultanément pendant les N intervalles de transmission précédents, B étant un paramètre,
- B+1 moyens de détection conjointe et moyens de décodage, en parallèle, pour détecter et séparer à partir du premier bloc les flux provenant des émetteurs, et pour détecter et séparer à partir des B blocs suivants les flux provenant des émetteurs et du relais et pour déterminer, pour chacun des B premiers blocs deux vecteurs représentatifs chacun de K bits d'information associés respectivement à deux mots de code en décodant simultanément les flux provenant des émetteurs détectés et séparés à partir d'un même bloc et le flux de redondance associé provenant du relais détecté et séparé lors de la détection conjointe du bloc suivant, le moyen de détection conjointe et le moyen de décodage d'un même bloc échangeant de manière itérative des informations souples représentatives des mots de code, le moyen de détection conjointe d'un bloc i+1 et le moyen de décodage d'un bloc i échangeant de manière itérative des informations souples représentatives de l'information de redondance associée aux mots de code du bloc i, $1 \leq i \leq B$.

**10.** Récepteur adapté pour un système MARC adapté pour mettre en oeuvre un procédé de transmission selon l'une des revendications 1 à 2, **caractérisé en ce qu'**il comprend

- B+1 moyens pour mémoriser B+1 blocs de données reçues correspondant à des paires de B mots de code émises simultanément respectivement par les deux émetteurs, chaque mot de code étant émis pendant N intervalles de transmission, un mot de code codant un bloc de K bits d'information, données reçues auxquelles sont associées B informations de redondance émises par le relais chacune pendant N intervalles de transmission telles que l'information de redondance émise pendant N intervalles de transmission correspond aux deux mots de code émis simultanément pendant les N intervalles de transmission précédents, le moyen B+1 mémorisant uniquement l'information de redondance correspondant au bloc précédent de données, B étant un paramètre,
- B+1 moyens de détection conjointe et moyens de décodage, en parallèle, pour détecter et séparer à partir du premier bloc les flux provenant des émetteurs, pour détecter séparer à partir des B-1 blocs suivants les flux provenant des émetteurs et du relais et pour détecter à partir du bloc B+1 le flux provenant du relais et pour déterminer en parallèle, pour chacun des B premiers blocs deux vecteurs représentatifs chacun de K bits d'information associés à un mot de code en décodant simultanément les flux provenant des émetteurs séparés à partir d'un même bloc et le flux de redondance associé provenant du relais et séparé lors de la détection conjointe du bloc suivant, le moyen de détection conjointe et le moyen de décodage d'un même bloc échangeant de manière itérative des informations souples représentatives des mots de code, le moyen de détection conjointe d'un bloc i+1 et le moyen de décodage d'un bloc i échangeant de manière itérative des informations souples représentatives de l'information de redondance associée aux mots de code du bloc i, 1≤i≤B.

**Patentansprüche**

1. Verfahren (1) zur Übertragung eines digitalen Signals, das für ein Netz mit mindestens vier Knoten bestimmt ist, umfassend zwei Sender, ein Relais und einen Empfänger, die untereinander durch Verbindungen getrennt sind, die einen räumlich verteilten Netzcode einsetzen, umfassend:

   - einen Schritt (2) der Codierung pro Sender nach einem Modulations- und Codierungsschema ($C_1$, $C_2$), das ein Codewort ($X_{S1}$, $X_{S2}$) pro Block von K Informationsbits liefert,
   - einen Schritt (3) des Sendens jeweils der beiden Codewörter in den beiden Sendern,

   **dadurch gekennzeichnet, dass**, da die Verbindungen nicht orthogonal sind, das Senden in den beiden Sendern während N Übertragungsintervallen gleichzeitig ist, und das Verfahren ferner umfasst:

   - im Relais einen Schritt (4) der gemeinsamen Erfassung, um die von den beiden Sendern kommenden Ströme zu trennen, und der Soft-Decodierung, um pro Strom einen Vektor von Wahrscheinlichkeiten a posteriori der decodierten Bits des empfangenen Codewortes zu bestimmen, wobei die Erfassung und Decodierung iterativ Soft-Informationen austauschen, die für die empfangenen Codewörter repräsentativ sind,
   - im Relais einen Schritt (5) der gemeinsamen Soft-Codierung von zwei Vektoren von Wahrscheinlichkeiten a posteriori, die jeweils aus zwei Strömen stammen, die für zwei gesandte Codewörter repräsentativ sind, nach einem Schema der binären Modulation mit Symbolen und der Codierung $C_R$, um eine Matrix von Wahrscheinlichkeiten a posteriori der Symbole zu erzeugen, der Bestimmung auf Basis dieser Matrix einer Matrix der Erwartungen der Symbole, die nach folgendem Ausdruck bestimmt werden:

$$E(s_{R,k,t}) = \sum_{j=0}^{|\chi_R|-1} b_j P(s_{R,k,t} = b_j),$$

   mit $b_j \in \chi_R$, $j=0,...,2^n-1$, wobei $\chi_R$ die Konstellation der Symbole in Verbindung mit der binären Modulation mit Kardinalitätssymbol $|\chi_R|=2^m$, $k=1,...,N$, $t=1,...,T_R$, ist, wobei $T_R$ die Anzahl von Sendeantennen des Relais ist, wobei $P(s_{R,k,t}=b_j)$ die Wahrscheinlichkeiten a posteriori der Symbole sind, und der Bestimmung einer Redundanzinformation auf Basis der Matrix der Erwartungen,
   - einen Schritt (6) des Sendens der Redundanzinformation während N Übertragungsintervallen durch das Relais,
   - eine derartige Ablaufplanung im Relais, dass die während N Übertragungsintervallen gesandte Redundanzinformation den während der N vorherigen Übertragungsintervalle gesandten Codewörtern entspricht.

2. Verfahren (1) nach Anspruch 1, ferner umfassend eine derartige Ablaufplanung in jedem Sender, dass der Sender kein Codewort während N Übertragungsintervallen sendet, nachdem er B Codewörter gesandt hat, wobei B ein Parameter ist.

3. Computerprogramm auf einem Informationsträger, wobei das Programm Programmbefehle umfasst, die an den Einsatz eines Verfahrens zur Übertragung eines digitalen Signals nach einem der Ansprüche 1 bis 2 angepasst sind, wenn das Programm in ein MARC-System, das dazu bestimmt ist, das Übertragungsverfahren einzusetzen, geladen ist und von diesem ausgeführt wird.

4. Informationsträger, umfassend Programmbefehle, die an den Einsatz eines Verfahrens zur Übertragung eines digitalen Signals nach einem der Ansprüche 1 bis 2 angepasst sind, wenn das Programm in ein MARC-System, das dazu bestimmt ist, das Übertragungsverfahren einzusetzen, geladen ist und von diesem ausgeführt wird.

5. Relais (R), das für ein MARC-System für den Einsatz eines Übertragungsverfahrens nach einem der Ansprüche 1 bis 2 bestimmt ist, **dadurch gekennzeichnet, dass** es umfasst:

   - ein gemeinsames Erfassungsmittel (MUD), um die Ströme, die von zwei Sendern des MARC-Systems kommen, zu trennen, und ein Mittel zur Soft-Decodierung, umfassend zwei Decoder (DEC1, DEC2) parallel, um aus zwei Strömen jeweils zwei Vektoren von Wahrscheinlichkeiten a posteriori von decodierten Bits zu bestimmen, die jeweils für K Informationsbits repräsentativ sind, die einem von einem Sender gesandten und von dem Relais empfangenen Codewort zugeordnet sind, wobei das Erfassungsmittel und das Decodierungsmittel iterativ Soft-Informationen austauschen, die für die empfangenen Codewörter repräsentativ sind,

- ein gemeinsames Mittel zur Soft-Codierung (Re_ENC) der beiden Vektoren von Wahrscheinlichkeiten a posteriori, die jeweils von zwei Strömen stammen, die für zwei gesandte Codewörter repräsentativ sind, nach einem binären Modulationsschema mit Symbol, und zur Codierung $C_R$, um eine Matrix von Wahrscheinlichkeiten a posteriori der Symbole zu erzeugen, ein Mittel zur Bestimmung auf Basis dieser Matrix einer Matrix der Erwartungen der Symbole, die nach folgendem Ausdruck bestimmt werden:

$$E(s_{R,k,t}) = \sum_{j=0}^{|\chi_R|-1} b_j P(s_{R,k,t} = b_j),$$

mit $b_j \in \chi_R$, $j=0,...,2^n-1$, wobei $\chi_R$ die Konstellation der Symbole in Verbindung mit der binären Modulation mit Kardinalitätssymbol $|\chi_R|=2^m$, $k=1,...,N$, $t=1,\cdots,T_R$, ist, wobei $T_R$ die Anzahl von Sendeantennen des Relais ist, wobei $P(s_{R,k,t}=b_j)$ die Wahrscheinlichkeiten a posteriori der Symbole sind, und ein Mittel zur Bestimmung einer Redundanzinformation auf Basis der Matrix der Erwartungen,

- ein Mittel, um die Redundanzinformation zu senden,

- ein Mittel zur Ablaufplanung, um während N Übertragungsintervallen eine Redundanzinformation zu senden, die den während der N vorherigen Übertragungsintervalle empfangenen Codewörtern entspricht.

6. MARC-System (SYS), bei dem das Relais nach Anspruch 5 ausgeführt ist.

7. Empfangsverfahren, das an einen Empfänger eines MARC-Systems angepasst ist, das dazu vorgesehen ist, ein Übertragungsverfahren nach einem der Ansprüche 1 bis 2 einzusetzen, **dadurch gekennzeichnet, dass** es umfasst:

- einen Schritt des Speicherns in B+1 Blöcken von empfangenen Daten, die Paaren von B+1 Codewörtern entsprechen, die gleichzeitig jeweils von den beiden Sendern jeweils während N Übertragungsintervallen gesandt werden, wobei ein Codewort einen Block von K Informationsbits codiert, wobei den empfangenen Daten B Redundanzinformationen zugeordnet sind, die von dem Relais jeweils während N Übertragungsintervallen gesandt werden, so dass die während N Übertragungsintervallen gesandte Redundanzinformation den beiden Codewörtern entspricht, die gleichzeitig während der N vorherigen Übertragungsintervalle gesandt wurden, wobei B ein Parameter ist,

- einen Schritt der gemeinsamen Erfassung und der Decodierung, parallel auf den B+1 Blöcken von empfangenen Daten, um auf Basis des ersten Blocks die Ströme zu erfassen und zu trennen, die von den Sendern kommen, und um auf Basis der B folgenden Blöcke die Ströme zu erfassen und zu trennen, die von den Sendern und dem Relais kommen, und um für jeden der B ersten Blöcke zwei Vektoren zu bestimmen, die jeweils für K Informationsbits repräsentativ sind, die jeweils zwei Codewörtern zugeordnet sind, wobei gleichzeitig die Ströme, die von den erfassten und getrennten Sendern eines selben Blocks kommen, und der zugehörige Redundanzstrom, der von dem erfassten und getrennten Relais bei der gemeinsamen Erfassung des folgenden Blocks kommt, decodiert werden, wobei ein Austausch von Soft-Informationen, die für die Codewörter repräsentativ sind, iterativ zwischen Erfassung und Decodierung eines selben Blocks stattfindet, und ein Austausch von Soft-Informationen, die für eine Redundanzinformation repräsentativ sind, iterativ zwischen Erfassung eines Blocks i+1 und Decodierung eines Blocks i stattfindet, wobei diese Redundanzinformation den Codewörtern des Blocks i zugeordnet ist, wobei $1 \leq i \leq B$.

8. Empfangsverfahren, das an einen Empfänger eines MARC-Systems angepasst ist, das dazu vorgesehen ist, ein Übertragungsverfahren nach einem der Ansprüche 1 bis 2 einzusetzen, **dadurch gekennzeichnet, dass** es umfasst:

- einen Schritt des Speicherns in B+1 Blöcken von empfangenen Daten, die Paaren von B Codewörtern entsprechen, die gleichzeitig jeweils von den beiden Sendern gesandt werden, wobei jeder Block während N Übertragungsintervallen gesandt wird, wobei ein Codewort einen Block von K Informationsbits codiert, wobei den empfangenen Daten B Redundanzinformationen zugeordnet sind, die von dem Relais jeweils während N Übertragungsintervallen gesandt werden, so dass die während N Übertragungsintervallen gesandte Redundanzinformation den beiden Codewörtern entspricht, die gleichzeitig während der N vorherigen Übertragungsintervalle gesandt wurden, wobei der Block B+1 nur eine Redundanzinformation entsprechend dem vorherigen Datenblock speichert, wobei B ein Parameter ist,

- einen Schritt der gemeinsamen Erfassung und der Decodierung, parallel auf den B+1 Blöcken, um auf Basis des ersten Blocks die Ströme zu erfassen und zu trennen, die von den Sendern kommen, und um auf Basis der B-1 folgenden Blöcke die Ströme zu erfassen und zu trennen, die von den Sendern und dem Relais kommen, und um auf Basis des Blocks B+1 den Strom zu erfassen, der von dem Relais kommt, und um parallel für jeden der B ersten Blöcke zwei Vektoren zu bestimmen, die jeweils für K Informationsbits repräsentativ sind, die einem Codewort zugeordnet sind, wobei gleichzeitig die Ströme, die von den getrennten Sendern eines selben Blocks kommen, und der zugehörige Redundanzstrom, der von dem Relais kommt und bei der gemeinsamen Erfassung des folgenden Blocks getrennt wurde, decodiert werden, wobei ein Austausch von Soft-Informationen, die für die Codewörter repräsentativ sind, iterativ zwischen Erfassung und Decodierung eines selben Blocks stattfindet, und ein Austausch von Soft-Informationen, die für eine Redundanzinformation repräsentativ sind, iterativ zwischen Erfassung eines Blocks i+1 und Decodierung eines Blocks i stattfindet, wobei diese Redundanzinformation den Codewörtern des Blocks i zugeordnet ist, wobei $1 \leq i \leq B$.

**9.** Empfänger, der an ein MARC-System angepasst ist, das dazu vorgesehen ist, ein Übertragungsverfahren nach einem der Ansprüche 1 bis 2 einzusetzen, **dadurch gekennzeichnet, dass** er umfasst:

- ein Mittel zum Speichern von B+1 Blöcken von empfangenen Daten, die Paaren von B+1 Codewörtern entsprechen, die gleichzeitig jeweils von den beiden Sendern gesandt werden, wobei jedes Codewort während N Übertragungsintervallen gesandt wird, wobei ein Codewort einen Block von K Informationsbits codiert, wobei den empfangenen Daten B Redundanzinformationen zugeordnet sind, die von dem Relais jeweils während N Übertragungsintervallen gesandt werden, so dass die während N Übertragungsintervallen gesandte Redundanzinformation den beiden Codewörtern entspricht, die gleichzeitig während der N vorherigen Übertragungsintervalle gesandt wurden, wobei B ein Parameter ist,

- B+1 Mittel zur gemeinsamen Erfassung und Mittel zur Decodierung, parallel, um auf Basis des ersten Blocks die Ströme zu erfassen und zu trennen, die von den Sendern kommen, und um auf Basis der B folgenden Blöcke die Ströme zu erfassen und zu trennen, die von den Sendern und dem Relais kommen, und um für jeden der B ersten Blöcke zwei Vektoren zu bestimmen, die jeweils für K Informationsbits repräsentativ sind, die jeweils zwei Codewörtern zugeordnet sind, wobei gleichzeitig die Ströme, die von den erfassten und getrennten Sendern eines selben Blocks kommen, und der zugehörige Redundanzstrom, der von dem erfassten und getrennten Relais bei der gemeinsamen Erfassung des folgenden Blocks kommt, decodiert werden, wobei das Mittel zur gemeinsamen Erfassung und das Mittel zur Decodierung eines selben Blocks iterativ Soft-Informationen, die für die Codewörter repräsentativ sind, austauschen, und das Mittel zur gemeinsamen Erfassung eines Blocks i+1 und das Mittel zur Decodierung eines Blocks i iterativ Soft-Informationen austauschen, die für die Redundanzinformation repräsentativ sind, die den Codewörtern des Blocks i zugeordnet ist, wobei $1 \leq i \leq B$.

**10.** Empfänger, der an ein MARC-System angepasst ist, das dazu vorgesehen ist, ein Übertragungsverfahren nach einem der Ansprüche 1 bis 2 einzusetzen, **dadurch gekennzeichnet, dass** er umfasst:

- B+1 Mittel zum Speichern von B+1 Blöcken von empfangenen Daten, die Paaren von B Codewörtern entsprechen, die gleichzeitig jeweils von den beiden Sendern gesandt werden, wobei jedes Codewort während N Übertragungsintervallen gesandt wird, wobei ein Codewort einen Block von K Informationsbits codiert, wobei den empfangenen Daten B Redundanzinformationen zugeordnet sind, die von dem Relais jeweils während N Übertragungsintervallen gesandt werden, so dass die während N Übertragungsintervallen gesandte Redundanzinformation den beiden Codewörtern entspricht, die gleichzeitig während der N vorherigen Übertragungsintervalle gesandt wurden, wobei das Mittel B+1 nur die Redundanzinformation speichert, die dem vorherigen Datenblock entspricht, wobei B ein Parameter ist,

- B+1 Mittel zur gemeinsamen Erfassung und Mittel zur Decodierung, parallel, um auf Basis des ersten Blocks die Ströme zu erfassen und zu trennen, die von den Sendern kommen, um auf Basis der B-1 folgenden Blöcke die Ströme zu erfassen und zu trennen, die von den Sendern und dem Relais kommen, und um auf Basis des Blocks B+1 den Strom zu erfassen, der von dem Relais kommt, und um parallel für jeden der B ersten Blöcke zwei Vektoren zu bestimmen, die jeweils für K Informationsbits repräsentativ sind, die einem Codewort zugeordnet sind, wobei gleichzeitig die Ströme, die von den getrennten Sendern eines selben Blocks kommen, und der zugehörige Redundanzstrom, der von dem Relais kommt und bei der gemeinsamen Erfassung des folgenden Blocks getrennt wurde, decodiert werden, wobei das Mittel zur gemeinsamen Erfassung und das Mittel zur Decodierung eines selben Blocks iterativ Soft-Informationen, die für die Codewörter repräsentativ sind, austauschen, und das Mittel zur gemeinsamen Erfassung eines Blocks i+1 und das Mittel zur Decodierung eines Blocks i iterativ Soft-Informationen austauschen, die für die Redundanzinformation repräsentativ sind, die den Codewörtern des Blocks i zugeordnet ist, wobei $1 \leq i \leq B$.

## Claims

1. Method (1) of transmitting a digital signal intended for a network with at least four nodes comprising two transmitters, a relay and a receiver which are mutually separated by links implementing a spatially distributed network code, comprising:

   - a step (2) of coding by transmitter according to a modulation and coding scheme ($C_1$, $C_2$), delivering a code word ($X_{S1}$, $X_{S2}$) per block of K information bits,
   - a step (3) of transmitting in the two transmitters respectively the two code words,

   **characterized in that** the links being orthogonal the transmitting in the two transmitters is simultaneous during N transmission intervals and the method furthermore comprises:

   - a step (4) in the relay of joint detection so as to separate the streams originating from the two transmitters and of soft decoding to determine, per stream, a vector of a posteriori probabilities of the decoded bits of the code word received, the detection and the decoding iteratively exchanging soft information representative of the code words received,
   - a step (5) in the relay, of joint soft coding of two vectors of a posteriori probabilities arising respectively from two streams representative of two code words transmitted, according to a binary to symbols modulation and coding scheme $C_R$ so as to produce a matrix of a posteriori probabilities of the symbols, of determining on the basis of this matrix a matrix of symbol expectations determined according to the expression:

   $$E(s_{R,k,t}) = \sum_{j=0}^{|\chi_R|-1} b_j P(s_{R,k,t} = b_j)$$ with $b_j \in \chi_R, j = 0,...,2^m - 1$, $\chi_R$ the constellation of the

   symbols which is associated with the binary to symbols modulation of cardinality $|\chi_R| = 2^m$, $k = 1,...,N$, $t = 1,...,T_R$, $T_R$ the number of transmit antennas of the relay, $P(s_{R,k,t} = b_j)$ the a posteriori probabilities of the symbols, and of determining an item of redundancy information on the basis of the matrix of expectations,
   - a step (6) of transmitting, by the relay, the item of redundancy information during N transmission intervals,
   - a scheduling in the relay such that the item of redundancy information transmitted during N transmission intervals corresponds to the code words sent during the N previous transmission intervals.

2. Method (1) according to Claim 1, furthermore comprising a scheduling in each transmitter such that the transmitter does not transmit any code word during N transmission intervals after having transmitted B code words, B being a parameter.

3. Computer program on an information medium, said program comprising program instructions adapted for implementing a method of transmitting a digital signal according to any one of Claims 1 to 2, when said program is loaded and executed in a MARC system intended to implement the method of transmission.

4. Information medium comprising program instructions adapted for the implementation of a method of transmitting a digital signal according to any one of Claims 1 to 2, when said program is loaded and executed in a MARC system intended to implement the method of transmission.

5. Relay (R) intended for a MARC system for the implementation of a method of transmission according to any one of Claims 1 to 2, **characterized in that** it comprises:

   - a means of joint detection (MUD) for separating the streams originating from two transmitters of the MARC system and a means of soft decoding comprising two decoders (DEC1, DEC2) in parallel so as to determine on the basis of two streams respectively two vectors of a posteriori probabilities of the decoded bits each representative of K information bits associated with a code word transmitted by a transmitter and received by the relay, the detection means and the decoding means iteratively exchanging soft information representative of the code words received,
   - a means of joint soft coding (Re_ENC) of the two vectors of a posteriori probabilities arising respectively from two streams representative of two code words transmitted according to a binary to symbols modulation and coding scheme $C_R$ so as to produce a matrix of a posteriori probabilities of the symbols, a means of determining on the basis of this matrix a matrix of symbol expectations determined according to the expression:

$$E(s_{R,k,t}) = \sum_{j=0}^{|\chi_R|-1} b_j P(s_{R,k,t} = b_j)$$

with $b_j \in \chi_R$, $j=0,...,2^m -1$, $\chi_R$ the constellation of the
symbols which is associated with the binary to symbols modulation of cardinality $|\chi_R| = 2^m$, $k = 1,...,N$, $t = 1,...,T_R$, $T_R$ the number of transmit antennas of the relay, $P(s_{R,k,t} = b_j)$ the a posteriori probabilities of the symbols, and a means of determining an item of redundancy information on the basis of the matrix of expectations,
- means for transmitting the item of redundancy information,
- a means of scheduling for transmitting during N transmission intervals an item of redundancy information which corresponds to the code words received during N previous transmission intervals.

6. MARC system (SYS) in which the relay is according to Claim 5.

7. Method of reception adapted to a receiver of a MARC system adapted for implementing a method of transmission according to one of Claims 1 to 2, **characterized in that** it comprises:

- a step of storing in B+1 blocks, data received corresponding to pairs of B+1 code words transmitted simultaneously respectively by the two transmitters, each during N transmission intervals, a code word coding a block of K information bits, received data with which are associated B items of redundancy information transmitted by the relay, each during N transmission intervals, such that the item of redundancy information transmitted during N transmission intervals corresponds to the two code words transmitted simultaneously during the N previous transmission intervals, B being a parameter,
- a step of joint detection and decoding, in parallel on the B+1 blocks of data received, so as to detect and separate on the basis of the first block the streams originating from the transmitters and to detect and separate on the basis of the B following blocks the streams originating from the transmitters and from the relay, and to determine for each of the B first blocks two vectors each representative of K information bits associated respectively with two code words by simultaneously decoding the streams originating from the transmitters detected and separated on the basis of one and the same block and the associated redundancy stream originating from the relay detected and separated during the joint detection of the following block, an exchange of soft information representative of the code words occurring iteratively between detection and decoding of one and the same block and an exchange of soft information representative of an item of redundancy information occurring iteratively between detection of a block i+1 and decoding of a block i, this item of redundancy information being associated with the code words of the block i, $1 \le i \le B$.

8. Method of reception adapted to a receiver of a MARC system adapted for implementing a method of transmission according to one of Claims 1 to 2, **characterized in that** it comprises:

- a step of storing in B+1 blocks, data received corresponding to pairs of B code words transmitted simultaneously respectively by the two transmitters, each block being transmitted during N transmission intervals, a code word coding a block of K information bits, received data with which are associated B items of redundancy information transmitted by the relay, each during N transmission intervals, such that the item of redundancy information transmitted during N transmission intervals corresponds to the two code words transmitted simultaneously during the N previous transmission intervals, the block B+1 storing only an item of redundancy information corresponding to the previous data block, B being a parameter,
- a step of joint detection and decoding, in parallel on the B+1 blocks so as to detect and separate on the basis of the first block the streams originating from the transmitters and to detect and separate on the basis of the B-1 following blocks the streams originating from the transmitters and from the relay and to detect on the basis of the block B+1 the stream originating from the relay and to determine in parallel for each of the B first blocks two vectors each representative of K information bits associated with a code word by simultaneously decoding the streams originating from the transmitters separated on the basis of one and the same block and the associated redundancy stream originating from the relay and separated during the joint detection of the following block, an exchange of soft information representative of the code words occurring iteratively between detection and decoding of one and the same block and an exchange of soft information representative of an item of redundancy information occurring iteratively between detection of a block i+1 and decoding of a block i, this item of redundancy information being associated with the code words of the block i, $1 \leq i \leq B$.

9. Receiver adapted for a MARC system adapted for implementing a method of transmission according to one of Claims 1 to 2, **characterized in that** it comprises:

- a means for storing B+1 blocks of data received corresponding to pairs of B+1 code words transmitted simultaneously respectively by the two transmitters, each code word being transmitted during N transmission intervals, a code word coding a block of K information bits, received data with which are associated B items of redundancy information transmitted by the relay, each during N transmission intervals, such that the item of redundancy information transmitted during N transmission intervals corresponds to the two code words transmitted simultaneously during the N previous transmission intervals, B being a parameter,
- B+1 means of joint detection and means of decoding, in parallel, so as to detect and separate on the basis of the first block the streams originating from the transmitters, and to detect and separate on the basis of the B following blocks the streams originating from the transmitters and from the relay and to determine, for each of the B first blocks two vectors each representative of K information bits associated respectively with two code words by simultaneously decoding the streams originating from the transmitters detected and separated on the basis of one and the same block and the associated redundancy stream originating from the relay detected and separated during the joint detection of the following block, the means of joint detection and the means of decoding of one and the same block iteratively exchanging soft information representative of the code words, the means of joint detection a block i+1 and the means of decoding of a block i iteratively exchanging soft information representative of the item of redundancy information associated with the code words of the block i, $1 \leq i \leq B$.

10. Receiver adapted for a MARC system adapted for implementing a method of transmission according to one of Claims 1 to 2, **characterized in that** it comprises:

- B+1 means for storing B+1 blocks of data received corresponding to pairs of B code words transmitted simultaneously respectively by the two transmitters, each code word being transmitted during N transmission intervals, a code word coding a block of K information bits, received data with which are associated B items of redundancy information transmitted by the relay, each during N transmission intervals, such that the item of redundancy information transmitted during N transmission intervals corresponds to the two code words transmitted simultaneously during the N previous transmission intervals, the means B+1 storing only the item of redundancy information corresponding to the previous data block, B being a parameter,
B+1 means of joint detection and means of decoding, in parallel, so as to detect and separate on the basis of the first block the streams originating from the transmitters and to detect and separate on the basis of the B-1 following blocks the streams originating from the transmitters and from the relay, and to detect on the basis of the block B+1 the stream originating from the relay and to determine in parallel, for each of the B first blocks two vectors each representative of K information bits associated with a code word by simultaneously decoding the streams originating from the transmitters separated on the basis of one and the same block and the associated redundancy stream originating from the relay and separated during the joint detection of the following block, the means of joint detection and the means of decoding of one and the same block iteratively exchanging soft information representative of the code words, the means of joint detection a block i+1 and the means of decoding of a block i iteratively exchanging soft information representative of the item of redundancy information associated with the code words of the block i, $1 \leq i \leq B$.

Fig. 1

Fig. 2

Fig. 3

**Fig. 4**

**Fig. 5**

**Fig. 6**

**Fig. 7**

**Fig. 8**

**Fig. 9**

DET/DEC

**Fig. 10**

MUD

**Fig. 11**

DECi

**Fig. 12**

**Fig. 13**

## Fig. 14

## Fig. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1729435 A

**Littérature non-brevet citée dans la description**

- **C. HAUSL ; F. SCHRENCKENBACH ; I. OIKONOMIDIS ; G. BAUCH.** Iterative network and channel coding on a Tanner graph. *Proc. Annual Allerton Conference on Communication,* 2005
- **C. HAUSL ; P. DUPRAZ.** Joint Network-Channel Coding for the Multiple-Access Relay Channel. *Proc. IEEE SECON'06,* Septembre 2006
- **S. YANG ; R. KOETTER.** Network coding over a noisy relay: A belief propagation approach. *Proc. IEEE,* Juin 2007
- **L.BAHL ; J.COCKE ; F.JELINEK ; J.RAVIV.** Optimal Decoding of Linear Codes for minimizing symbol error rate. *IEEE Transactions on Information Theory,* Mars 1974, 284-287
- **TUYEN BUI ; JINHONG YUAN.** Iterative approaches of cooperative transmission based on superposition modutation. *international symposium on communications and information technologies,* 2007, 1423-1428